Europäisches Patentamt

(19) **European Patent Office**

**Office européen des brevets**

(11) Numéro de publication: **0 011 341**

**B1**

(12) **FASCICULE DE BREVET EUROPEEN**

(45) Date de publication du fascicule du brevet: **02.06.82**

(51) Int. Cl.³: **H 04 B 12/04**

(21) Numéro de dépôt: **79200657.9**

(22) Date de dépôt: **09.11.79**

(54) **Système de transmission utilisant la modulation différentielle par codage d'impulsions.**

(30) Priorité: **17.11.78 FR 7832508**

(43) Date de publication de la demande:
**28.05.80 Bulletin 80/11**

(45) Mention de la délivrance du brevet:
**02.06.82 Bulletin 82/22**

(84) Etats contractants désignés:
**BE DE FR GB IT SE**

(56) Documents cités:
**ALTA FREQUENZA, vol. 46, no. 8, août 1977, Milan (IT) DECINA: "Multiple ADPCM codecodings of speech signals", pages 362—186E à 364—186E.**

(73) Titulaire: **TELECOMMUNICATIONS RADIOELECTRIQUES ET TELEPHONIQUES T. R. T. 88, rue Brillat Savarin F-75013 Paris (FR)**

(72) Inventeur: **Bonnerot, Georges Société Civile S.P.I.D. 209 rue de l'Université F-75007 Paris (FR)**

(74) Mandataire: **Tissot, Jean et al, Société Civile S.P.I.D. 209, rue de l'Université F-75007 Paris (FR)**

Courier Press, Leamington Spa, England.

**0011 341**

Système de transmission utilisant la modulation différentielle par codage d'impulsions

L'invention concerne un système de transmission numérique d'informations, utilisant la modulation différentielle par codage d'impulsions et comportant un codeur dans lequel le signal MIC différentiel à transmettre résulte de la quantification du signal de différence entre le signal MIC linéaire entrant et un signal de prédiction fourni par un filtre de prédiction comportant un décodeur local recevant ledit signal MIC différentiel, le décodeur local et le décodeur distant comportant des filtres de même structure.

On sait que dans le réseau de transmission numérique normalisé par la CEPT, les signaux transmis dans chaque voie sont formés de mots de 8 bits apparaissant à la cadence d'échantillonnage de 8 kHz, ce qui procure dans chaque voie un débit binaire de 64 k bits/s. Chaque mot de 8 bits résulte de la compression suivant une loi logarithmique approchée de chaque échantillon du signal à transmettre, codé linéairement avec 12 bits au moyen de la modulation par impulsions et codage (MIC).

Or on cherche maintenant, dans le réseaux de transmission numériques, à réduire le débit binaire dans chaque voie, en vue d'augmenter la capacité de transmission de ces réseaux. Un moyen pour y parvenir, décrit dans le brevet italien n° 984 398, consiste à déduire du signal MIC normalisé un signal MIC différentiel formé en utilisant la technique de modulation différentielle par codage d'impulsions et apte à être transmis avec un nombre de bits réduit. Suivant cette technique, on obtient dans un codeur un signal MIC différentiel numérique en quantifiant un signal de différence entre le signal MIC linéarisé entrant et un signal de prédiction; ce signal de prédiction est déduit de la sortie d'un décodeur local auquel est appliqué le signal MIC différentiel qui est transmis vers le décodeur distant. En utilisant en outre un système de compression syllabique pour adapter la grandeur de l'échelon de quantification du signal de différence au niveau de ce signal de différence, il est théoriquement possible d'obtenir avec une qualité satisfaisante un signal MIC différentiel à 4 bits permettant la transmission vers le décodeur distant, avec un débit binaire de 32 k bits/s, ce qui permet de doubler la capacité d'une voie de transmission prévue pour un débit de 64 k bits/s.

Mais l'utilisation dans les réseaux existants de signaux MIC différentiel pour la transmission, pose des problèmes qui ne semblent pas avoir été résolus jusqu'à présent. Dans les centres nodaux du réseau, les commutations sont prévues pour être effectuées sur des signaux MIC comprimés et normalisés à 8 bits de sorte que chaque liaison nécessite une cascade de conversions de signal MIC comprimé à 8 bits en signal MIC différentiel et de signal MIC différentiel en signal MIC comprimé à 8 bits. Pour le premier type de conversion, on doit prévoir un dispositif d'extension fournissant le signal MIC linéaire à appliquer à un codeur MIC différentiel du genre décrit ci-dessus. Pour le deuxième type de conversion, on doit prévoir à la sortie du décodeur MIC différentiel distant un dispositif de compression pour convertir le signal MIC linéaire fourni par ce décodeur en signal MIC comprimé à 8 bits.

Dans une liaison utilisant une cascade de conversions MIC-MIC différentiel et inversement, il risque de se produire pour diverses raisons une accumulation du bruit produit à chaque conversion, du fait de la nature numérique des signaux traités. En particulier les codeurs et décodeurs pour signaux MIC différentiels comportent des filtres numériques; au filtre du décodeur local inclus dans le codeur pour former le signal de prédiction doit correspondre un filtre identique dans le décondeur distant pour former le signal codé; de même, au filtre syllabique inclus dans le codeur pour former le signal commandant la grandeur de l'échelon de quantification doit correspondre un filtre identique dans le décodeur distant; les filtres correspondants doivent bien entendu fournir le même signal en réponse au même signal. Or on sait que des filtres numériques, même attaqués par le même signal, peuvent fournir des signaux différents du fait de leur mémoire interne. Il est clair que s'il en est ainsi pour les filtres correspondants des codeurs et des décodeurs distants, la transmission en MIC différentiel n'est pas possible sans dégradation. Par ailleurs, si aucune précaution n'est prise dans les codeurs et décodeurs, pour effectuer les nécessaires opérations de limitation du nombre de bits (par arrondi on troncation), on risque une accumulation du bruit produit par ces opérations lors de chaque conversion MIC-MIC différentiel et inversement. On risque également une accumulation du bruit produit lors de chaque conversion par les opérations d'extension ou de compression nécessaires dans une liaison utilisant une cascade de conversions. Pour toutes ces raisons, il peut se produire une dégradation inadmissible du signal dans une liaison utilisant pour la transmission, des signaux MIC différentiel.

La présente invention a pour but d'éviter ces difficultés de façon à ne produire dans une liaison nécessitant un certain nombre de conversions MIC-MIC différentiel, aucune autre dégradation du signal que celle produite par une seule conversion.

Conformément à l'invention, dans un système de transmission utilisant la modulation différentielle par codage d'impulsions, les filtres formant le décodeur local et le décodeur distant sont constitués chacun par une ou plusieurs cellules de filtrage en cascade de type purement récursif et/ou non récursif ayant une seul coefficient différent de zéro, et les quantificateurs utilisés pour arrondir (ou tronquer) les signaux dans lesdites cellules de filtrage et le signal MIC linéaire entrant sont commandés pour effectuer les opérations d'arrondi (ou de troncation) avec un pas égal à la grandeur de l'échelon de quantification dudit signal de différence.

2

# 0011341

On montrera dans la description détaillée du système de l'invention, que le décodeur local et le décodeur distant ayant la structure définie ci-dessus, s'alignent après un temps limité (c'est-à-dire fournissent après un temps limité le même signal si le même signal leur est appliqué), lorsqu'on applique au codeur un signal aléatoire tel qu'un signal de parole ou de données. Il en résulte qu'après la durée nécessaire à cet alignement le décodeur distant fournit le même signal MIC linéaire que celui appliqué au codeur, ce qui permet le montage en cascade de codeurs et de décodeurs sans autre dégradation du signal que celle produite par le premier codage.

Lorsque dans le système de transmission de l'invention, l'échelon de quantification du signal MIC différentiel est réglé automatiquement au moyen de réseaux de compression identiques incorporés dans le décodeur local et le décodeur distant, les filtres syllabiques inclus dans ces réseaux de compression ont également la même structure que celle préconisée ci-dessus. De cette mainière, après un temps limité nécessaire pour l'alignement des ces filtres syllabiques, le codeur et le décodeur distant travaillent avec le même échelon de quantification, ce qui permet le montage en cascade de codeurs et de décodeurs à échelon de quantification variable.

La description suivante, en regard des dessins annexés, le tout donné à titre d'exemple, fera bien comprendre comment l'invention peut être réalisée.

La figure 1 est un schéma indiquant la structure générale connue d'un codeur et du décodeur distant associé, dans un système de transmission MIC différentiel.

La figure 2 est un schéma de deux filtres purement récursifs du premier ordre, dont les entrées sont interconnectées.

La figure 3 est un diagramme destiné à montrer comment les deux filtres de la figure 2 peuvent s'aligner.

La figure 4 est un schéma d'un filtre purement récursif du deuxième ordre ayant un seul coefficient différent de zéro.

Les figures 5 et 6 sont des schémas représentant respectivement un mode de réalisation d'un décodeur et d'un codeur dans le système de l'invention.

Les figures 7 et 8 sont des schémes d'un autre mode de réalisation d'un décodeur et d'un codeur dans le système de l'invention.

La figure 9 représente de façon simplifiée les éléments nécessaires pour la conversion en cascade d'un signal MIC comprimé en signal MIC différentiel et inversement.

La figure 10 est un schéma montrant la structure générale connue d'un codeur muni d'un circuit quantificateur écrêteur.

Les figures 11 et 12 sont des diagrammes montrant respectivement les courbes de réponse d'un quantifacteur linéaire et d'un quantifacteur non linéaire.

La figure 13 est le schéma d'un codeur conforme à l'invention destiné à pallier les inconvénients produits par l'écrêtage avec le codeur de la figure 10.

Les figures 14 et 15 sont respectivement les schémas d'un codeur et du décodeur distant associé dans un système de transmission conforme à l'invention, utilisant un échelon de quantification variable.

La figure 16 est un diagramme montrant les diverses réponses possibles pour le quantifacteur variable utilisé dans le codeur de la figure 14.

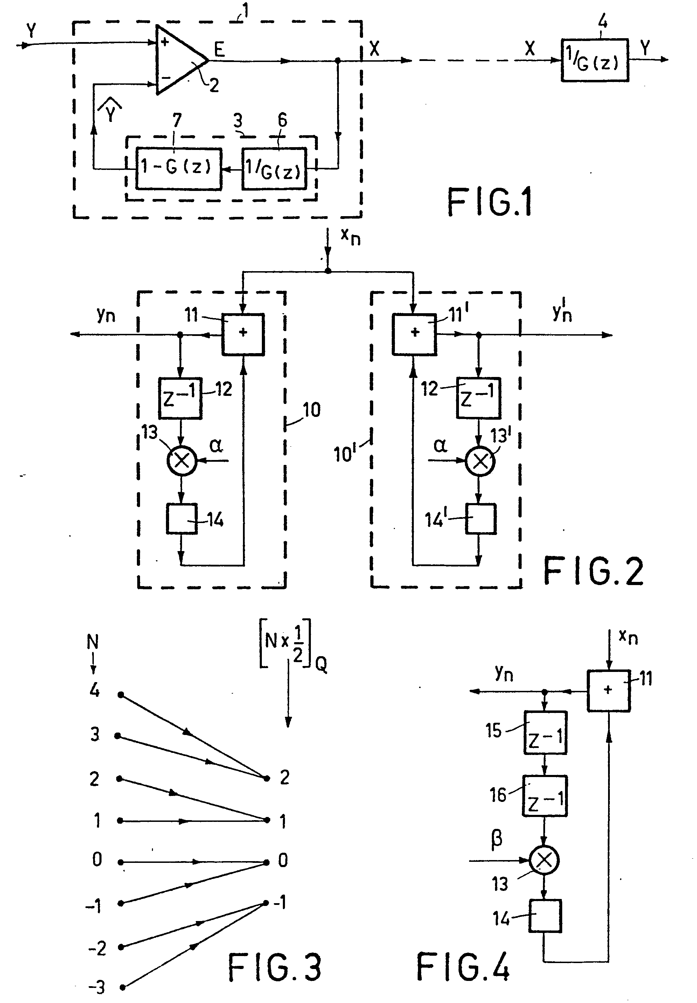

Un codeur et le décodeur distant qui lui est associé dans un système de transmission utilisant la modulation différentielle par codage d'impulsions, peuvent être représentés sous la forme du schéma simplifié de la figure 1.

A l'entrée du codeur 1 est appliqué le signal MIC Y, formé d'échantillons codés linéairement à 12 bits. Ce signal Y est appliqué à une entrée (+) d'un circuit de différence 2 dont l'autre entrée (−) reçoit un signal de prédiction $\hat{Y}$. Le signal de prédiction $\hat{Y}$ est formé à la sortie du filtre de prédiction 3 qui reçoit le signal de sortie X du codeur. Ce signal MIC différentiel X est appliqué également au décodeur distant 4 qui doit normalement fournir le même signal Y que celui qui est appliqué à l'entrée du codeur 1. On suppose pour l'instant que le signal de sortie X du codeur est le même que le signal de différence E fourni par la sortie du circuit de différence 2, alors que le signal X résulte normalement d'une quantification du signal E, avec par exemple 4 bits, comme on l'expliquera par la suite.

Le filtre de prediction 3 comporte en cascade un décodeur local 6 qui reçoit le même signal X que le décodeur distant 4 et l'opérateur 7 qui fournit le signal de prédiction $\hat{Y}$. Le décodeur distant 4 et le décodeur local 6 ont la fonction de transfert d'un filtre, par exemple celle d'un filtre purement récursif qui peut se représenter, en raisonnant sur les transformées en Z des signaux, par la fonction de transfer en Z:

$$\frac{1}{G(z)}.$$

Le codeur 1 doit évidemment avoir la fonction de transfert inverse de celle du décodeur distant 4; dans l'exemple choisi cette fonction de transfert du codeur est G(z), soit celle d'un filtre non récursif et l'on vérifie aisément que l'opérateur 7 doit alors réaliser l'opération [1−G(z)].

L'utilisation de filtres numériques pour réaliser les décodeurs 4 et 6 pose des problèmes qui

3

peuvent rendre le système de la figure 1 inutilisable, notamment dans une liaison comportant plusieurs de ces systèmes en cascade. En effet, certains filtres numériques, même attaqués par le même signal, peuvent dans certaines conditions fournir des signaux différents. Si les filtres formant le décodeur distant 4 et le décodeur local 6 présentent ce comportement, on ne retrouve pas à la sortie du décodeur distant 4 le même signal que celui appliqué au codeur 1. En outre dans une liaison comportant une cascade de codeurs et de décodeurs, on doit éviter l'accumulation du bruit produit par les opérations de limitation du nombre de bits à effecteur dans chaque codeur et décodeur.

L'invention fournit les moyens d'éviter ces difficultés en indiquant la structure des filtres numériques à utiliser et les mesures à prendre dans ces filtres pour effecteur les opérations de limitation du nombre de bits.

On examine d'abord d'une manière générale le type de filtres susceptibles d'être utilisés. On distingue les filtres non récursifs dont la fonction de transfert en Z ne présente que des zéros, des filtres purement récursifs dont la fonction de transfert en Z ne présente que des pôles.

En ce qui concerne les filtres non récursifs, on sait que leur sortie ne dépend que d'un nombre fini de nombres d'entrée consécutifs. Par conséquent, si l'on considère deux filtres identiques de ce type, auxquels on applique le même signal d'entrée, mais démarrant avec des conditions initiales différentes, c'est-à-dire avec des nombres stockés dans leur mémoire interne différents, on est certain qu'au bout d'un temps fini correspondant au renouvellement complet desdits nombres stockés, les deux filtres fourniront le même signal de sortie. Pour représenter cette propriète, on peut appeler les filtres non récursifs, des filtres "absolument convergents".

En ce qui concerne les filtres purement récursifs, on sait que leur sortie à chaque instant dépend non seulement d'un nombre fini de nombres d'entrée consécutifs, mais également d'un nombre fini de nombres de sortie précédents. Par conséquent, un tel type de filtre conserve la mémoire des conditions initiales et on ne peut garantir de façon absolue que deux filtres identiques de ce genre auxquels on applique le même signal d'entrée, mais démarrant avec des conditions initiales différentes donneront la même sortie en un temps fini.

Par contre pour certains types de filtres purement récursifs, on peut garantir que la probabilité d'obtenir la même sortie pour le même signal d'entrée tend vers 1 avec le temps. Les filtres de ce type sont appelés par la suite des filtres "statistiquement convergents".

Les filtres purement récursifs du premier ordre, ayant la fonction de transfert

$$\frac{1}{1-Z^{-1}\alpha}$$

($\alpha$ étant le coefficient du filtre) sont un premier type de filtres statistiquement convergents. Pour le montrer, on a représenté sur la figure 2, deux filtres identiques de ce genre 10, 10', recevant le même signal d'entrée $x_n$, n étant un indice représentant le temps à des instants nT, multiples de l'intervalle d'échantillonnage T. Comme le montre la figure, chaque filtre 10, 10' comporte le circuit additionneur 11, 11' dont une entrée reçoit le signal $x_n$ et dont la sortie est connectée au registre 12, 12' procurant un retard T (fonction $Z^{-1}$), suivi du circuit multiplicateur 13, 13' effectuant la multiplication par le coefficient $\alpha$, le produit formé étant limité en nombre de bits par le circuit 14, 14'. Pour simplifier, on suppose par la suite que les opérations de limitation de nombre de bits sont des opérations d'arrondi, tout ce qui est dit à ce sujet étant valable également pour des troncations. La sortie du circuit 14, 14' est connectée à l'ature entrée du circuit additionneur 11, 11'. Les sorties des filtres 10 et 10' sont prises aux sorties des circuits additionneurs 11 et 11'. Les signaux de sortie aux instants nT sont appelés respectivement $y_n$ et $y'_n$.

On suppose donc qu'à l'instant initial tel que n=0, le contenu des deux circuits de retard 12, 12' est respectivement $y_o$ et $y'_o$ avec $y_o - y'_o \neq 0$.

Si l'on utilise pour les deux filtres un coefficient $\alpha=1$, leurs signaux de sortie resteront toujours différents car l'écart initial $y_o - y'_o$ sera conservé indéfiniment.

Par contre si l'on utilise pour les deux filtres un coefficient $\alpha<1$, l'écart entre leurs signaux de sortie diminuerait forcément si les circuits d'arrondi 14, 14' n'existaient pas. Mais, puisque toutes les opérations dans ces filtres sont effectuées en numérique, ces circuits d'arrondi sont nécessaires pour limiter le nombre des bits du résultat des calculs effectués à chaque intervalle d'échantillonnage et il convient d'examiner dans quelles conditions on peut obtenir, avec des opérations d'arrondi, la convergence des deux filtres.

On suppose, pour simplifier l'explication, que le coefficient $\alpha$ est égal à

$$\frac{1}{2}$$

et l'on examine d'après le diagramme de la figure 3 le résultat de la multiplication d'un nombre entier N par

$$\alpha = \frac{1}{2}$$

avec arrondi consécutif. Sur ce tableau on a représenté sur la première colonne une suite de quelques nombres entiers N voisins de zéro et sur la deuxième colonne, le résultat de la multiplication de ces nombres par

$$\frac{1}{2}$$

avec arrondi, les traits fléchés indiquant la correspondance entre les nombres des deux colonnes. Il est clair que pour les nombres N pairs la multiplication par

$$\alpha = \frac{1}{2}$$

est exacte. Pour les nombres N impairs, les résultat de la multiplication par

$$\frac{1}{2}$$

avec arrondi revient à une multiplication par un coefficient différent de

$$\frac{1}{2}$$

et plus petit que 1, sauf pour N=1 pour lequel ce coefficient vaut 1.

A un instant nT quelconque les sorties $y_n$ et $y'_n$ des deux filtres 10, 10' peuvent s'écrire:

$$\begin{cases} y_n = x_n + \alpha_n y_{n-1} \\ y'_n = x_n + \alpha'_n y'_{n-1} \end{cases}$$

Dans ces formules $\alpha_n$ et $\alpha'_n$ sont des coefficients tenant compte de l'arrondi effectué après multiplication par

$$\frac{1}{2}$$

du contenu $y_{n-1}$ et $y'_{n-1}$ des deux registres 12, 12'. On peut écrire à ce sujet:

$$\begin{cases} \alpha_n y_{n-1} = \dfrac{1}{2} y_{n-1} + \Delta \\ \\ \alpha'_n y'_{n-1} = \dfrac{1}{2} y'_{n-1} + \Delta' \end{cases}$$

$\Delta$ et $\Delta'$ étant des termes pouvant prendre les valeurs

$$0 \text{ ou } \frac{1}{2}.$$

On en déduit:

(1) $$y_n - y'_n = \frac{1}{2}[y_{n-1} - y'_{n-1}] + [\Delta - \Delta']$$

Dans cette dernière expression (1), $[\Delta - \Delta']$ peut prendre les valeurs

$$\frac{1}{2},$$

$$0 \text{ ou } \frac{1}{2}.$$

**0011 341**

On voit que tant que les contenus $y_{n-1}$ et $y'_{n-1}$ des deux registres 12, 12' sont tels que:

$$|y_{n-1}-y'_{n-1}|>1,$$

on aura:

$$|y_n-y'_n|<|y_{n-1}-y'_{n-1}|,$$

ce qui indique que les sorties $y_n$ et $y'_n$ des deux filtres à l'instant nT vont se rapprocher.

Lorsque

$$|y_{n-1}-y'_{n-1}|=1,$$

l'écart entre les sorties des deux filtres à l'instant nT, peut demeurer constant ou s'annuler.

Dans le cas où $y_{n-1}-y'_{n-1}=1$, on voit aisément d'après le tableau de la figure 3, que si $y_{n-1}$ est un nombre pair, $y_n-y'_n=0$, et si $y_{n-1}$ est un nombre impair, $y_n-y'_n=1$. L'inverse se produit si $y_{n-1}-y'_{n-1}=-1$.

En conclusion, si dans deux filtres purement récursifs du premier ordre ayant intialement dans leurs registres-mémoires des contenus différents, on utilise un coefficient multiplicateur $\alpha$ égal à

$$\frac{1}{2},$$

l'écart entre les sorties de ces deux filtres diminue forcément jusqu'à devenir égal à 1. Ensuite une valeur sur deux du contenu d'un registre ou de l'autre permet d'annuler cet écart, c'est-à-dire d'obtenir la convergence des deux filtres. Comme le contenu des deux registres est fonction des nombres $x_n$ appliqués en commun à l'entrée des deux filtres, on peut dire que lorsque l'écart entre leurs sorties est égal à 1, une valeur sur deux de ces nombres d'entrée permet ensuite d'obtenir la convergence finale. Si le signal constitué par ces nombres d'entrée est aléatoire, la probabilité pour que l'écart se maintienne à 1, tend vers zéro avec le temps. Pour cette raison, les filtres ayant cette propriété sont appelés filtres statistiquement convergents.

Dans le cas plus général où l'on utilise pour ces deux filtres du premier ordre un coefficient multiplicateur $\alpha$ ayant la forme

$$1-\frac{c}{d},$$

l'écart entre les sorties des deux filtres diminue jusqu'à devenir égal à 1, en un nombre fini d'intervalles élémentaires T d'autant plus fabile que

$$\frac{c}{d}$$

est proche de 1. Ensuite, c valeurs sur d valeurs des nombres appliqués à l'entrée des deux filtres contribuent à leur convergence finale. Pour un signal d'entrée aléatoire, la probabilité de conserver un écart égal à 1 tend vers zéro avec le temps.

Les filtres purement récursifs d'ordre supérieur à 1 ne répondent pas dans le cas le plus général à la propriété de convergence statistique. Toutefois cette propriété est obtenue pour certains de ces filtres.

Un premier type de filtres purement récursifs d'ordre quelconque et répondant à la propriété de convergence statistique, est obtenu par la mise en cascade de cellules de filtrage du premier ordre ayant la fonction de transfert en Z définie ci-dessus, avec un coefficient inférieur à 1. Par exemple, un filtre du deuxième ordre de ce type a la fonction de transfert:

$$\frac{1}{(1-Z^{-1}\alpha_1)(1-Z^{-1}\alpha_2)},$$

$\alpha_1$ et $\alpha_2$ étant respectivement les coefficients des deux cellules du premier ordre mises en cascade.

Un autre type de filtre purement récursif d'ordre m quelconque et répondant à la propriété de convergence statistique, est un filtre ayant un seul coefficient différent de zéro et dont la fonction de transfert en Z peut s'écrire:

$$\frac{1}{[1-Z^{-m}\beta]},$$

6

$\beta$ étant le coefficient du filtre qui peut être positif ou négatif et qui satisfait à la condition de convergence statistique $|\beta|<1$.

Par exemple un filtre du deuxième ordre de ce type a la fonction de transfert en Z:

$$\frac{1}{1-Z^{-2}\beta}.$$

Avec un coefficient $\beta$ négatif, et de valeur absolue inférieure à 1, ce filtre comporte deux pôles représentés dans le plan des Z par deux valeurs imaginaires pures conjuguées. Le schéma d'un tel filtre du deuxième ordre est représenté à la figure 4. Ce filtre comporte certains éléments identiques au filtre 10 de la figure 2 et munis des mêmes références. Toutefois, la sortie du circuit additionneur 11 est connectée à une entrée du multiplicateur 13 effectuant la multiplication par $\beta$, par l'intermédiaire de deux circuits de retard en cascade 15 et 16, procurant chacun le retard T (fonction $Z^{-1}$ pour chaque circuit). Le filtre du deuxième ordre de la figure 4 répond à la propriété de convergence statistique, car on peut le considérer comme un ensemble de deux filtres du premier ordre sur lesquels sont répartis les échantillons $x_n$ du signal d'entrée ayant la fréquence

$$\frac{1}{T},$$

chacun de ces filtres travaillant à la fréquence moitié

$$\frac{1}{2T}.$$

Des filtres de ce type, d'ordre quelconque m, ont la structure indiquée à la figure 4, avec toutefois m circuits de retard dans leur boucle, au lieu de deux.

Enfin, n'importe quel filtre qui peut se mettre sous une forme cascade de cellules de filtrage du premier ordre et/ou de cellules de filtrage d'ordre quelconque supérieur à un et ayant un seul coefficient différent de zéro, est statistiquement convergent, à condition toutefois que les opérations d'arrondi soient effectuées séparément dans chaque cellule de filtrage composant ce filtre.

Dans le système de transmission MIC différentiel montré à la figure 1, on peut réaliser selon l'invention, le décodeur distant 4 et le décodeur local 6 au moyen d'un filtre purement récursif, du type à convergence statistique que l'on vient de définir. En supposant par exemple que ce filtre est constitué par une cascade de cellules de filtrage de type récursif du premier ordre et du deuxième ordre, la fonction

$$\frac{1}{G(z)}$$

de ces décodeurs peut s'écrire:

$$(2) \qquad \frac{1}{G(z)} = \pi^{p}_{i=0}\frac{1}{[1-\alpha_i Z^{-1}]} \cdot \pi^{r}_{j=0}\frac{1}{[1-\beta_j Z^{-2}]}$$

Dans cette formule (2), $\alpha_i$ et $\beta_j$ sont respectivement les coefficients des p cellules du premier ordre et des r cellules du deuxième ordre, qui composent le filtre.

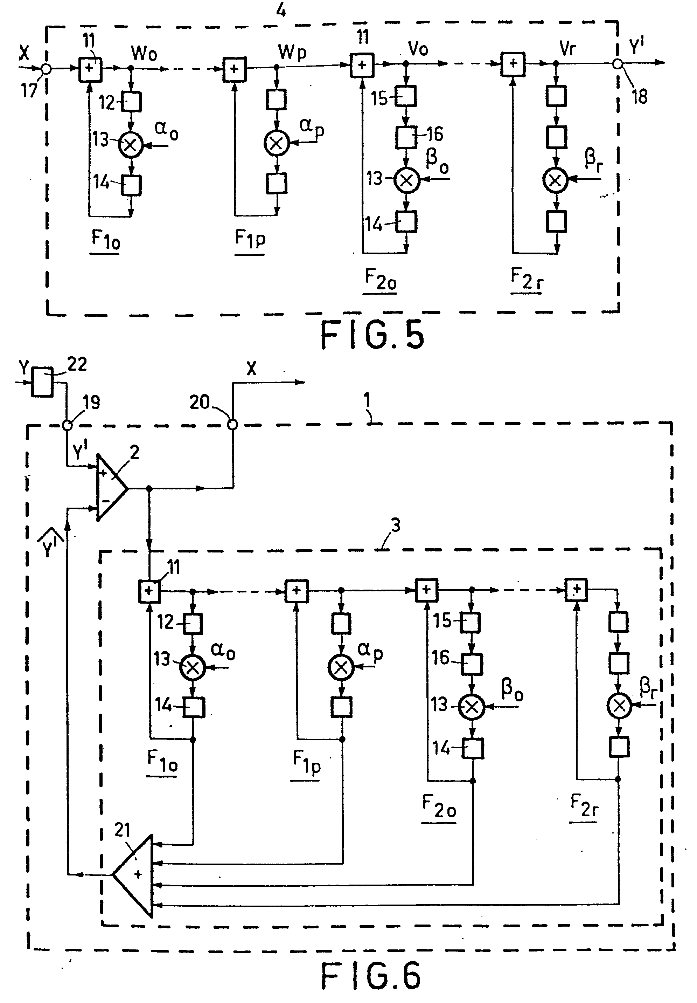

Un mode de réalisation d'un décodeur utilisant un tel filtre est représenté à la figure 5. Ce mode de réalisation concerne plus particulièrement le décodeur distant 4, car on verra qu'en utilisant des sorties particulières sur le décodeur local ayant cette structure, on peut réaliser très simplement la fonction complète du filtre de prédiction 3 du codeur, soit

$$[1-G(z)]\frac{1}{G(z)}.$$

Le décodeur de la figure 5 comporte donc entre son entrée 17 et sa sortie 18 une cascade de cellules récursives du premier ordre $F_{10} \ldots F_{1p}$, ayant les coefficients $\alpha_o \ldots \alpha_p$, en série avec une cascade de cellules récursives du deuxième ordre $F_{20} \ldots F_{2r}$, ayant chacune un seul coefficient non nul $\beta_o \ldots \beta_r$. Chaque cellule du premier ordre telle que $F_{10}$ comporte les mêmes éléments munis des mêmes références que les filtre 10 sur la figure 2; chaque cellule du deuxième ordre telle que $F_{20}$ comporte les mêmes éléments munis des mêmes références que le filtre de la figure 4. Ce décodeur reçoit le signal X codé en MIC différentiel et fournit le signal codé en MIC linéaire.

**0011341**

Pour réaliser un codeur correspondant au décodeur de la figure 5 et ayant donc la fonction de transfert G(z), on doit réaliser la fonction

$$\frac{1}{G(z)}[1-G(z)]$$

du filtre de prédiction 3 (voir figure 1). Pour expliquer comment est réalisée cette fonction suivant l'invention, on appelle, comme le montre la figure 5, $W_o \dots W_p$, les signaux de sortie des cellules du premier ordre $F_{10} \dots F_{1p}$ et $V_o \dots V_r$ les signaux de sortie des cellules du deuxième ordre $F_{20} \dots F_{2r}$.

On peut montrer qu'en utilisant ces signaux, le produit

$$X \cdot \frac{1}{G(z)}[1-G(z)]$$

qui définit le signal de prédiction peut se mettre sous la forme:

$$X \cdot \frac{1}{G(z)} \quad (z)] = \alpha_o W_o^{n-1} + \dots + \alpha_p W_p^{n-1} + \beta_o V_o^{n-2} + \dots \beta_r V_r^{n-2}$$

Dans cette formule, les termes $W_o^{n-1}$ à $W_p^{n-1}$ sont les sorties des cellules du premier ordre $F_{10}$ à $F_{1p}$ à l'instant $(n-1)T$ et les terms $V_o^{n-2}$ à $V_r^{n-2}$ sont les sorties des cellules du deuxième ordre à l'instant $(n-2)T$. On voit aisément que les produits de la formule ci-dessus sont disponibles dans un décodeur tel que celui de la figure 5 à la sortie des circuits multiplicateurs 13, et après arrondi sont disponibles à la sortie des circuits d'arrondi 14; en formant donc à chaque instant nT, la somme de ces produits on obtient le signal de prédiction à cet instant nT.

Le schéma d'un codeur 1 à associer au décodeur distant 4 est donc celui représenté à la figure 6. Ce codeur est muni d'une entrée 19 reliée à l'entrée (+) du circuit de différence 2 et d'une sortie 20 connectée à la sortie du circuit de différence 2 qui fournit le signal MIC différentiel X. Ce signal X est appliqué au filtre de prédiction 3 qui comprend le même montage en cascade de filtres du premier ordre $F_{10}$ à $F_{1p}$ et due deuxième ordre $F_{20}$ à $F_{2r}$ ayant un seul coefficient non nul, que le décodeur distant 4 de la figure 5. Chaque cellule du premier et du deuxième ordre est munie de la même manière de son propre dispositif d'arrondi 14. La fonction globale du filtre de prédiction 3,

$$\frac{1}{G(z)}[1-G(z)]$$

est réalisée en formant à l'aide du circuit additionneur 21, la somme des signaux arrondis par les circuits 14. A la sortie du circuit additionneur 21, on obtient le signal de prédiction qui est appliqué à l'entrée (—) du circuit différence 2.

On va maintenant montrer que dans un système de transmission utilisant le codeur et le décodeur distant des figures 6 et 5, le décodeur distant peut fournir à sa sortie 18 rigoureusement le même signal que celui qui est appliqué à l'entrée 19 du codeur, en effectuant dans chaque cellule de filtrage $F_{10}$ à $F_{2r}$ du codeur et due décodeur la même opération d'arrondi avec un pas égal à l'échelon de quantification du signal MIC différentiel transmis X et en effectuant également si nécessaire une opération d'arrondi identique sur le signal MIC linéaire à coder.

Le pas de quantification du signal MIC différentiel transmis peut être constant ou variable dans un système à compression syllabique que l'on décrira par la suite. Dans le deux cas il est possible d'effecteur les opérations d'arrondi requises, de la même manière dans le codeur et dans le décodeur. Dans les cellules de filtrage $F_{10}$ à $F_{2r}$ du codeur et du décodeur l'opération d'arrondi est effectuée comme on l'a déjà indiqué au moyen des circuits d'arrondi 14. Sur la figure 6, on a par ailleurs représenté un circuit d'arrondi 22 qui reçoit le signal MIC linéaire Y à coder, supposé non arrondi, et qui fournit le signal Y' résultant de l'arrondi du signal Y au pas du signal MIC différentiel X.

Dans le système de transmission utilisant le codeur et le décodeur des figures 6 et 5, le signal MIC différentiel X est appliqué simultanément au montage en cascade des cellules de filtrage $F_{10}$ à $F_{2r}$ du codeur et du décodeur. Comme ces cellules sont du type à convergence statistique et que l'arrondie v est effectué de la même manière au pas de quantification du signal MIC différentiel X, les cellules d codeur et les cellules du décodeur fourniront après convergence exactement les mêmes signaux forme de nombres entiers avec une unité correspondant au pas de quantification du signal X. Il en résulte que dans le codeur le circuit de prédiction fournit après convergence un signal de prédiction $\hat{Y}'$ arrondi de la même manière et formé également de nombres entiers, la fonction de transfert de ce filtre de prédiction étant

8

**0011341**

$$\frac{\hat{Y}'}{X} = \frac{1}{G'(z)}[1-G'(z)].$$

Comme le signal Y' appliqué à l'entrée 19 du codeur est également formé de nombres entiers (à cause de l'arrondi effectué par le circuit 22), le circuit de différence 2 fournit le signal d'erreur Y'−$\hat{Y}'$ qui est formé également de nombres entiers et qui constitue le signal MIC différentiel X, la fonction de transfert du codeur étant

$$\frac{X}{Y'}=G'(z).$$

Le décodeur distant de la figure 5 auquel on applique le même signal X que celui qui est appliqué au filtre de prédiction, a la fonction de transfert

$$\frac{1}{G'(z)}$$

et fournit donc à sa sortie 18 le même signal Y' arrondi au pas du signal MIC différentiel que celui appliqué à l'entrée 19 du codeur.

Si l'on monte en cascade un certain nombre de codeurs 1 et de décodeurs 4 conformes aux figures 6 et 5, en appliquant au premier codeur un signal Y' arrondi au pas du signal MIC différentiel transmis, tous les codeurs s'aligneront c'est-à-dire fourniront le même signal MIC différentiel X et tous les décodeurs s'aligneront c'est-à-dire fourniront le même signal MIC linéaire Y' arrondi, la probabilité de l'alignement complet tendant vers 1 avec le temps. En effet les codeurs ont la fonction de transfert

$$\frac{1}{G'(z)}$$

de filtres récursifs du type à convergence statistique et les décodeurs ont la fonction de transfer G'(z) de filtres non récursifs à convergence absolue. Il est remarquable que dans un tel montage en cascade de codeurs et de décodeurs on n'introduit aucune autre dégradation du signal que celle produite par le premier codeur et résultant notamment de l'arrondi effectué à l'entrée du premier codeur par le circuit 22 et des arrondis effectués dans les cellules de filtrage par les circuits d'arrondi 14.

Dans le système de transmission de l'invention envisagé jusqu'à présent, le décodeur distant et le décodeur local inclus dans le codeur sont des filtres à forme purement récursive correspondant à la fonction de transfert

$$\frac{1}{G(z)}$$

donnée par la formule (2).

Selon un autre mode de réalisation de l'invention, le décodeur local et le décodeur distant peuvent être constitués chacun par un filtre comprenant en cascade un partie purement récursive du type à convergence statistique avec une fonction de transfert

$$\frac{1}{G(z)}$$

et une partie non récursive avec une fonction de transfert H(z). Pour des raisons que l'on expliquera par la suite, la partie non récursive doit avoir une structure de même nature que celle assignée à la partie purement récursive, c'est-à-dire doit être formée par une cascade de cellules non récursives du premier ordre et/ou de cellules non récursives d'ordre supérieur à un, ayant un seul coefficient différent de zéro, chaque cellule étant munie de son propre dispositif d'arrondi. Ce filtre comporte à la fois des pôles et des zéros. En supposant qu'il ne comporte que des cellules du premier ordre et du second ordre, sa fonction de transfert

$$\frac{H(z)}{G(z)}$$

9

peut s'exprimer comme un produit comprenant comme l'indique la formule (3) ci-dessous une partie identique à la formule (2) pour représenter la fonction

$$\frac{1}{G(z)}$$

et une partie pour représenter la fonction H(z).

$$(3) \quad \frac{H(z)}{G(z)} = \pi^p_{i=0} \frac{1}{1-\alpha_i Z^{-1}} \cdot \pi^r_{j=0} \frac{1}{1-\beta_j Z^{-2}} \cdot \pi^s_{k=0}(1-a_k Z^{-1}) \cdot \pi^\omega_{l=0}(1-b_k Z^{-2})$$

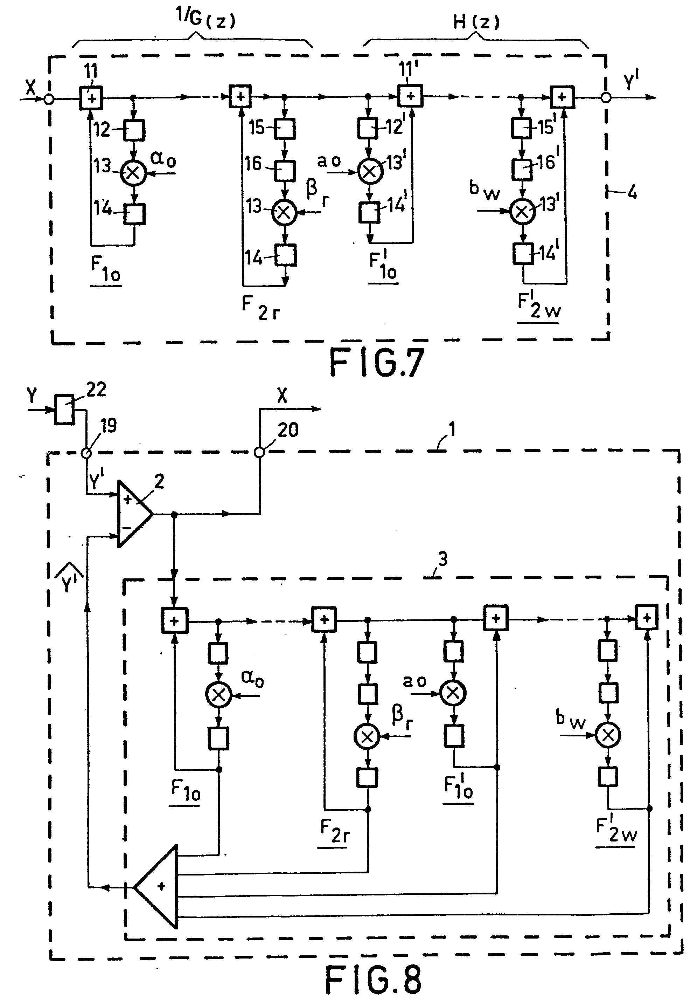

La figure 7 représente le schéma d'un décodeur distant 4 ayant la fonction de transfert

$$\frac{H(z)}{G(z)}$$

de la formule (3). Sur ce schéma un certain nombre d'éléments sont identiques à ceux du schéma de la figure 5 et sont référencés de la même manière. La partie purement récursive ayant la fonction

$$\frac{1}{G(z)}$$

est représentée par les cellules $F_{10} \ldots F_{2r}$ ayant la même structure que sur la figure 5. En série avec cette partie purement récursive est connectée la partie non récursive ayant la fonction de transfert H(z) et composée de s cellules du premier ordre dont on n'a représenté que la première $F'_{10}$ et de $\omega$ cellules du deuxième ordre ayant un seul coefficient différent de zéro, seule la dernière cellule du deuxième ordre $F'_{2\omega}$ ayant été représentée. Les cellules non récursives du premier ordre telles que $F'_{10}$ sont composées des mêmes éléments que les cellules récursives telles que $F_{10}$, ces éléments étant référencés de la même manière avec un accent. Mais le montage en série du circuit de retard 12', du circuit multiplicateur 13' et du circuit d'arrondi 14' se trouve branché entre les deux entrées du circuit additionneur 11', au lieu de l'être entre la sortie et l'entrée de cet additionneur. Tout ceci est égalemment le cas pour une cellule non récursive du deuxième ordre telle que $F'_{2\omega}$, vis à vis d'une cellule récursive du deuxième ordre telle que $F_{2r}$.

Un codeur 1 correspondant au décodeur distant 4 de la figure 7 peut être réalisé suivant le schéma de la figure 8. Sur ce schéma on retrouve un certain nombre d'éléments identiques à ceux du codeur de la figure 6 et référencés de la même manière. Dans le filtre de prédiction 3 on utilise un décodeur local identique au décodeur distant et formé par le montage en cascade des cellules $F_{10} \ldots F_{24}, F'_{10} \ldots F'_{2\omega}$. En formant au moyen du circuit additionneur 21, la somme des signaux obtenus à la sortie des différents circuits d'arrondi 14 et 14', on obtient le signal de prédiction. Le filtre de prédiction réalise la fonction de transfert

$$\frac{H(z)}{G(z)} \left[ 1 - \frac{G(z)}{H(z)} \right].$$

Un système de transmission utilisant en cascade des codeurs et des décodeurs conformes aux figures 7 et 8 présente les mêmes caractéristiques que celles indiquées ci-dessus pour un système utilisant les codeurs et décodeurs des figures 5 et 6. En effet le décodeur à fonction de transfert

$$\frac{H(z)}{G(z)}$$

n'utilise que des cellules de filtrage du type à convergence statistique ou du type à convergence absolue. Le codeur présente la fonction de transfert

$$\frac{G(z)}{H(z)},$$

dans laquelle la partie purement récursive

## 0011 341

$$\frac{1}{H(z)}$$

correspond à un montage en cascade de cellules purement récursives du type à convergence statistique, par suite de la fonction H(z) choisie. Finalement en appliquant à un montage en cascade de tels codeurs et décodeurs un signal Y' arrondi au pas due signal MIC différentiel X et en effectuant le même arrondi dans les circuits 14, 14' de chaque cellule, on obtient rigoureusement après convergence à la sortie de chaque codeur le même signal MIC différentiel X et à la sortie de chaque décodeur le même signal MIC linéaire arrondi Y'. Dans ce montage en cascade, seule la première conversion produit une dégradation du signal.

On peut remarquer que si dans les codeurs il est indispensable d'effecteur l'opération d'arrondi au moyen de circuits 14 et 14' placés directement après les multiplicateurs 13 et 13' pour obtenir un signal de prédiction Ŷ' arrondi, on pourrait aussi bien dans les décodeurs effectuer les opérations d'arrondi à la sortie des circuits additionneurs 11 et 11'. Enfin tout ce qui a été indiqué ci-dessus est bien entendu valable si l'on effectue des troncations au lieu d'arrondis pour limiter le nombre de bits, l'essentiel étant que les opérations de limitation de nombre de bits soient faites aux endroits indiqués et de la manière indiquée.

Dans un réseau de communication numérique utilisant la technique de transmission en MIC différentiel que l'on vient de décrire et devant transmettre des signaux téléphoniques et des signaux de données, le filtre constituant le décodeur distant et le décodeur local inclus dans le codeur doit être un filtre passe-bas qui doit transmettre le mieux possible, à la fois les signaux de parole et les signaux de données. On sait que le spectre des signaux de parole en téléphonie se trouve du côté des basses fréquences, avec une amplitude décroissant de 9 dB/Octave au-delà de 800 Hz. Le spectre des signaux de données a son maximum à la fréquence 1800 Hz de la porteuse. On a trouvé qu'un bon compromis entre les signaux de parole et de données était obtenu en utilisant comme décodeurs un filtre ayant la fonction de transfert:

$$\frac{H(z)}{G(z)} = \frac{(1+\frac{1}{2}Z^{-1})}{(1-\frac{1}{2}Z^{-1})^2(1+\frac{1}{2}Z^{-2})}$$

Ce filtre de compromis est composé de cellules de filtrage répondant aux critères ci-dessus indiqués et a l'avantage de n'utiliser que des coefficients très simples

$$\pm\frac{1}{2}.$$

On a supposé jusqu'à présent que dans le système de transmission de l'invention, on appliquait au codeur un signal MIC linéaire (c'est-à-dire formé de nombres résultant d'un codage linéaire d'échantillons). Or on sait que dans le réseau de transmission numérique normalisé par la CEPT, les échantillons du signal MIC sont transmis après avoir subi une compression instantanée faisant passer les échantillons codés linéairement avec 12 bits en échantillons comprimés codés avec 8 bits. Il en résulte que si l'on veut utiliser, dans un réseau numérique existant le système de transmission en MIC différentiel décrit jusqu'à présent, on doit faire précéder chaque codeur d'un circuit d'extension de MIC comprimé à 8 bits en MIC linéaire à 12 bits, tandis que chaque décodeur doit être suivi d'un circuit de compression effectuant l'opération inverse.

On va maintenant examiner les conséquences qui en résultent et les mesures à prendre dans le système de l'invention.

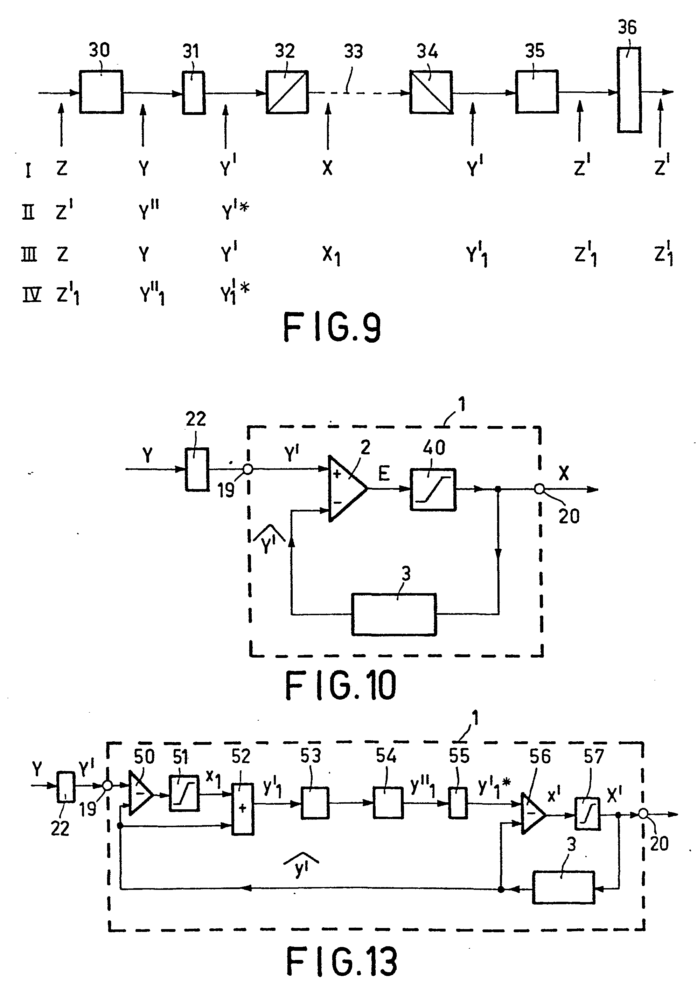

Sur la figure 9, on montre un montage en cascade utilisant les codeurs et décodeurs de l'invention et comprenant des circuits nécessaires de compression et d'extension pour traiter des nombres d'un signal MIC comprimé. Sur le schéma de la figure 9, on a indiqué sur la ligne I les références des signaux se produisant en différents points du circuit, lors d'une première transmission.

Pour une première transmission le signal MIC comprimé à 8 bits Z est appliqué à un circuit d'extension 30 connu en soi, qui fournit un signal MIC linéaire Y à 12 bits. Ce dernier est appliqué à un circuit d'arrondi 31 effectuant un arrondi au pas du MIC différentiel, ce qui signifie un arrondi avec un pas égal à l'échelon de quantification du signal MIC différentiel X. Ce circuit 31 joue un rôle analoque au circuit d'arrondi 22 sur les figures 6 et 8 et fournit un signal MIC linéaire arrondi Y'. On ne peut spécifier le nombre de bits non nuls du signal Y', ce nombre de bits dépendant du pas du MIC

11

différentiel ut à pour l'arrondi. Dans le système MIC différentiel décrit par la suite, ce pas est d'ailleurs variable. Le s al Y' est appliqué à un codeur 32 fournissant un signal MIC différentiel X qui est transmis via un milieu de transmission 33 à un décodeur 34. On a expliqué ci-dessus, qu'en utilisant un codeur 32 et un décodeur 34 conformes à l'invention, on obtient à la sortie du décodeur 34, le même signal Y' arrondi que celui applique au codeur 32 et qui est bien entendu différent du signal MIC linéaire d'origine Y. Si l'on doit revenir à un signal MIC comprimé à 8 bits, par exemple pour effectuer une commutation dans un central à commutation temporelle 36, on doit utiliser un circuit de compression 35 qui effectue l'opération in verse du circuit d'extension 30 et qui fournit un signal comprimé à 8 bits Z' qui est en général différent du signal comprimé d'origine Z.

Si l'on veut effectuer à partir du signal Z' sortant du central 36 une nouvelle transmission en MIC différentiel, on doit répeter les mêmes opérations que celles décrites jusqu'à présent à l'aide des circuits identiques. Pour ne pas répeter le même schéma, on a indiqué sur la figure 9 que, pour cette nouvelle transmission, on applique le signal Z' (représenté sur la ligne II) à l'entrée du circuit d'extension 30; ce dernier fournit un signal Y'' qui peut être différent du signal Y d'origine utilisé pour la première transmission. Ce signal Y'' procure à la sortie du circuit d'arrondi 31, un signal Y'* qui peut aussi être différent du signal Y' utilisé pour la première transmission. Il risque donc de se produire une accumulation des erreurs à chaque transmission.

On va montrer que si dans le circuit d'arrondi 31, après avoir changé le signe des nombres du signal Y, on effectue on arrondi au pas du MIC différentiel sur ces nombres changés de signe, puis on revient au signe initial pour les nombres ainsi arrondis, on obtient toujours à la sortie de ce circuit 31 le même signal arrondi Y'. Autrement dit, avec les notations utilisées ci-dessus, le traitement du signal Y' dans le montage en cascade du circuit de compression 35, du circuit d'extension 30 et du circuit d'arrondi 31 doit fournir un signal Y'*=Y'. Cette opération particulière d'arrondi, appelée par la suite pour simplifier "arrondi avec changement de signe", a pour but d'inverser le rôle des bornes des intervalles semi-ouverts définissant les nombres donnant le même arrondi.

En effectuant donc dans le circuit 31 un arrondi avec changement de signe au pas $\Delta$ du signal MIC différentiel, on obtient des nombres arrondis Y' multiples de $\Delta$($Y'=K\Delta$) et appartenant à l'intervalle semi-ouvert tel que:

$$(4) \qquad Y' \varepsilon \left[ Y-\frac{\Delta}{2}, Y+\frac{\Delta}{2} \right[$$

Par ailleurs l'opération de compression-extension des nombres du signal Y' dans les circuits 35 et 30 est équivalente à un opération d'arrondi "normal" avec un pas $\Delta'$ dépendant de l'amplitude du nombre et il en résulte des nombres Y'' multiples de $\Delta'$($Y''=k'\Delta'$) et appartenant à l'intervalle semi-ouvert tel que:

$$(5) \qquad Y'' \varepsilon \left] Y'-\frac{\Delta'}{2}, Y'+\frac{\Delta'}{2} \right]$$

Enfin, l'opération d'arrondi avec changement de signe dans le circuit 31 sur les nombres Y'', permet d'écrire:

$$(6) \qquad Y'* \varepsilon \left[ Y''-\frac{\Delta}{2}, Y''+\frac{\Delta}{2} \right[$$

On remarque d'après les formules (4), (5), (6) que le côté où sont ouverts les intervalles dépend du type d'arrondi correspondant arrondi avec changement de signe ou arrondi normal.

Etant donné que le pas $\Delta$ du signal MIC différentiel peut être variable, ainsi que le pas $\Delta'$ de l'arrondi auquel est équivalente l'opération de compression-extension, on doit envisager tous les cas possibles des valeurs de $\Delta$ par rapport à celles de $\Delta'$.

Un premier cas est celui où

$$\frac{\Delta'}{2} < \frac{\Delta}{2}.$$

La combinaison des formules (5) et (6) permet d'écrire:

$$Y'* \varepsilon \left] Y'-\frac{\Delta'}{2}-\frac{\Delta}{2}, Y'+\frac{\Delta'}{2}+\frac{\Delta}{2} \right[$$

Comme

12

$$\frac{\Delta'}{2} < \frac{\Delta}{2},$$

on en déduit:

$$Y'^* \varepsilon ]Y'-\Delta, \; Y'+\Delta[$$

Comme $Y'^*=k\Delta$, on obtient $Y'^*=Y'$, ce qui est le résultat recherché.

L'autre cas que l'on envisage maintenant est celui où

$$\frac{\Delta'}{2} \geqslant \frac{\Delta}{2}.$$

La combinaison des formules (4) et (5) permet d'écrire:

$$]Y'' \varepsilon \quad Y - \frac{\Delta}{2} - \frac{\Delta'}{2}, Y + \frac{\Delta}{2} + \frac{\Delta'}{2}[$$

Dans le cas où

$$\frac{\Delta'}{2} > \frac{\Delta}{2}$$

et dans le pire des cas où

$$\frac{\Delta'}{2} = \frac{\Delta}{2},$$

on peut écrire:

$$Y'' \varepsilon ]Y - \Delta', \; Y + \Delta'[$$

Comme $Y''=k'\Delta'$, on en déduit $Y''=Y$, et évidemment à la sortie du circuit d'arrondi 31, on obtient le résultat recherché, à savoir $Y'^*=Y'$.

Ainsi, dans tous les cas, en effectuant dans le circuit 31, un arrondi avec changement de signe, on peut mettre en cascade les circuits codeurs et décodeurs de l'invention décrits jusqu'à présent, associés à des circuits d'extension et de compression de signal MIC.

En se reportant maintenant aux schémas des codeurs de l'invention des figures 6 et 8, on a supposé jusqu'à présent que pour coder un signal MIC linéaire Y en un signal MIC différentiel X, les seules opérations non linéaires effectuées étaient des opérations d'arrondi: arrondi avec changement de signe sur le signal Y pour obtenir le signal arrondi Y' et arrondi normal effectué dans les différentes cellules de filtrage du filtre deprédiction pour obtenir le signal de prédiction arrondi Y'. Ces opérations d'arrondi sont effectuées avec un pas égal à l'échelon de quantification du signal MIC différentiel et on obtient à la sortie du circuit de différence 2, un signal de différence E arrondi avec le même pas. On a identifié jusqu'à présent le signal MIC différentiel X fourni par le codeur au signal de différence E. Or on veut transmettre un signal MIC différentiel X ne comportant qu'un nombre réduit de bits, 4 bits par exemple, alors que le signal de différence E comporte un nombre de bits à valeur variable plus grand que quatre, le bit de plus faible poids à valeur variable ayant un poids égal à l'échelon de quantification du MIC différentiel.

Comme le montre le schéma simplifié du codeur de la figure 10, qui comporte des éléments identiques à ceux des figures 6 et 8 et référencés de la même manière, on doit donc disposer à la sortie du circuit de différence 2 un circuit quantificateur-écrêteur 40 qui, à l'intérieur d'une certaine plage, quantifie le signal de différence E selon une loi déterminée, pour former le signal MIC différentiel X à 4 bits variables et qui, à l'extérieur de cette plage, écrête le signal E pour former un signal X positif ou négatif ayant la même valeur quel que soit le signal E.

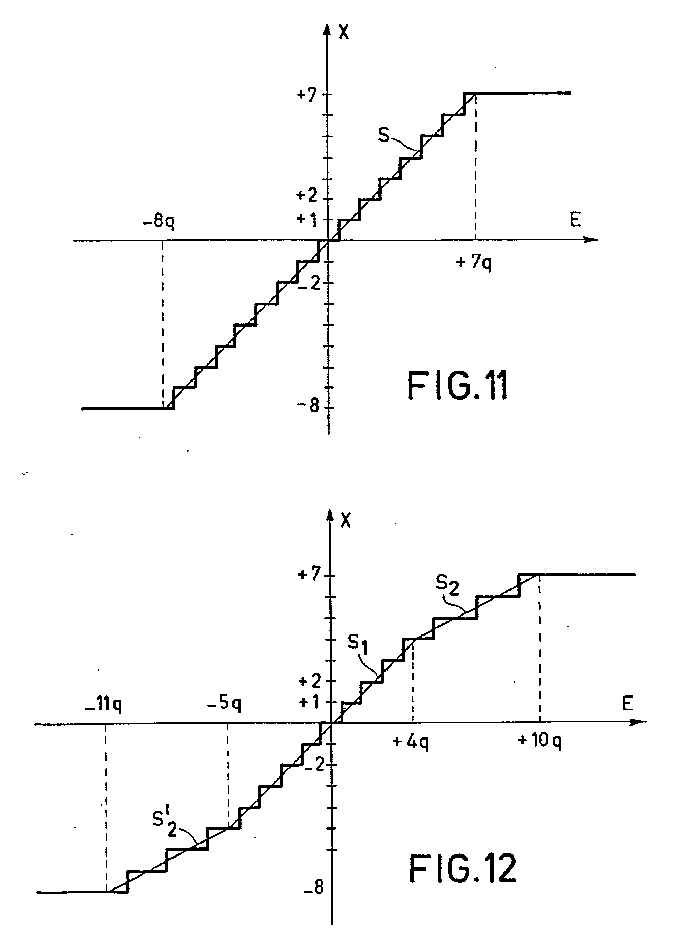

On indique par exemple sur la figure 11, la réponse X en fonction de E pour un quantificateur-écrêteur ayant une loi de quantification linéaire. Le signal X à 4 bits, supposé exprimé dans le code des compléments à deux, peut prendre 16 valeurs discrètes allant de $-8$ à $+7$. La quantification est effectuée avec le même pas $\Delta=q$ pour des valeurs de E situées dans la plage allant de $-8q$ à $+7q$; dans cette plage la réponse X en fonction de E est représentée par une courbe en marches d'escalier située de part et d'autre d'un segment S de pente

# 0011341

$$\frac{1}{\Delta} = \frac{1}{q}.$$

A l'extérieur de cette plage, le signal de différence E est écrêté et la valeur du signal X reste égale à +7 pour les valeurs du signal E positives et égale à −8 pour les valeurs du signal E négatives.

On peut utiliser également une loi de quantification non linéaire telle que celle illustrée à titre d'exemple sur la figure 12. On voit sur cette figure représentant avec la même échelle que sur la figure 11 la réponse X en fonction de E, que la quantification est effectuée avec le pas $\Delta=q$ pour des valeurs de E situées dans la plage allant de −5q à +4q; dans cette plage la réponse X en fonction de E est représentée par une courbe en maches d'escalier entourant le segment $S_1$ de pente

$$\frac{1}{\Delta} = \frac{1}{q}.$$

Dans deux plages due signal E s'étendant de +4q à +10q et de −5q à −11q, la quantification est effectuée avec le pas $\Delta=2q$; dans ces deux plages la réponse X en fonction de E est représentée ar deux portions de courbe en marches d'escalier entourant les deux segments $S_2$, $S'_2$ de pente

$$\frac{1}{\Delta} = \frac{1}{2q}.$$

A l'extérieur de la plage allant de −11q à +10q, le signal de différence E est écrête et la valeur de X reste égale à +7 ou à −8. La comparaison des figures 11 et 12 montre clairement que l'utilisation d'une quantification non linéaire permet d'augmenter le plage des valeurs du signal E quantifiées sans écrêtage. Une quantification non linéaire peut bien entendu être effectuée suivant une lois plus compliquée que celle de la figure 12 et utilisant plus de deux échelons de quantification.

On va maintenant examiner le problème que peut poser la fonction d'écrêtage décrite ci-dessus, dans un système formé d'un montage en cascade de codeurs et de décodeurs associés à des circuits de compression et d'extension, tel que celui représenté à la figure 9. On suppose maintenant que sur cette figure le codeur 32 comporte un quantificateur-écrêteur ayant une loi de quantification linéaire, du type décrit à la figure 11. Il est clair tout d'abord que, tant qu'il ne se produit pas dans ce codeur 32 un écrêtage du signal de différence E, le fonctionnement du montage en cascade de la figure 9 est exactement celui décrit ci-dessus, à l'aide des signaux référencés aux lignes I et II.

Sur la ligne III de la figure 3, on indique les différents signaux qui apparaissent aux différents points du schéma lors d'une première transmission, lorsque l'on utilise un codeur 32 dans lequel le signal de différence E est écrêté. A l'entrée du circuit d'extension 30, du circuit d'arrondi avec changement de signe 31 et du codeur 32 apparaissent les mêmes signaux que ceux indiqués sur la ligne I, soit respectivement Z, Y, Y'. A la sortie du codeur 32 dans lequel on suppose que le signal de différence E se trouve écrêté, il apparaît par contre un signal $X_1$ différent du signal X sur la ligne I et après transmission à travers la ligne 33, ce signal $X_1$ produit à la sortie du décodeur 34 et du circuit de compression 35 des signaux $Y'_1$ et $Z'_1$ différents des signaux correspondants Y' et Z' sur la ligne I. Si, en vue d'une nouvelle transmission en MIC différentiel, on veut effectuer un nouveau codage on obtient à l'entrée d'un circuit d'extension tel que 30, d'un circuit d'arrondi tel que 31 et à l'entrée d'un codeur tel que 32, les signaux indiqués sur la ligne IV, c'est-à-dire respectivement $Z'_1$, $Y''_1$ et $Y'^*_1$.

On peut définir les intervalles auxquels appartiennent les signaux Y', $Y''_1$ et $Y'^*_1$ au moyen des trois relations (4a), (5a), (6a), de façon analogue aux relations (4), (5), (6) ci-dessus:

$$(4a) \qquad Y'\varepsilon \left[ \, Y - \frac{\Delta}{2} \, , \, Y + \frac{\Delta}{2} \, \right[ \quad \text{avec } Y' = k\Delta$$

$$(5a) \qquad Y''_1\varepsilon \left] \, Y'_1 - \frac{\Delta'}{2} \, , \, Y'_1 + \frac{\Delta'}{2} \, \right] \quad \text{avec } Y''_1 = k'\Delta'$$

$$(6a) \qquad Y'^*_1\varepsilon \left[ \, Y''_1 - \frac{\Delta}{2} \, , \, Y''_1 + \frac{\Delta}{2} \, \right[ \quad \text{avec } Y'^*_1 = k\Delta$$

$\Delta$ et $\Delta'$ ont les significations déjà indiquées.

14

Dans le cas où

$$\frac{\Delta'}{2} < \frac{\Delta}{2},$$

en combinant les formules (5a) et (6a), on montre aisément que $Y'^*_1 = Y'_1$. Dans le condeur 32 auquel, poure une nouvelle transmission, on applique donc le signal $Y'_1$, il ne se produira plus d'écrêtage du signal de différence E et par conséquent on obtiendra ce signal $Y'_1$ à la sortie du décodeur distant 34. Ceci montre que dans le cas où

$$\frac{\Delta'}{2} < \frac{\Delta}{2},$$

on peut monter en cascade des codeurs ayant une fonction d'écrêtage et des décodeurs, avec circuits de compression et d'extension associés, sans qu'il se produise d'autres dégradation du signal (notamment par écrêtage) que celles produits dans le premier codeur.

Dans le cas où

$$\frac{\Delta'}{2} \geqslant \frac{\Delta}{2},$$

il n'est pas possible de combiner les relations (4a) et (5a) comme on l'a fait pour les relations correspondantes (4) et (5) et lorsqu'il y a écrêtage du signal de différence E dans le codeur 32, le signal $Y''_1$ à l'entrée du circuit d'arrondi 31 pour une nouvelle transmission est différent du signal correspondant Y pour la première transmission. Il peut se produire alors une dégradation du signal par écrêtage, lors de chaque codage.

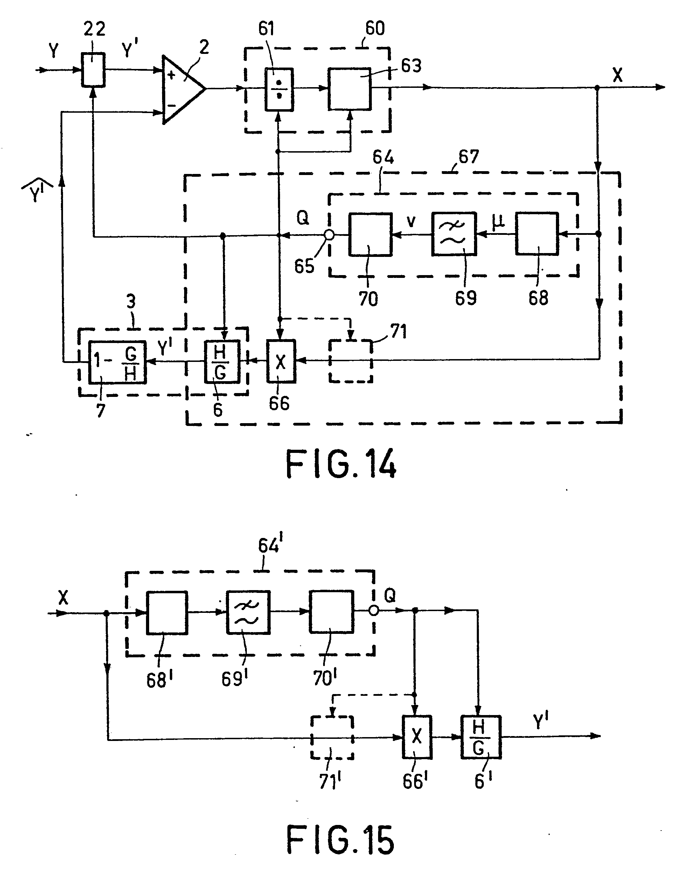

Pour éviter cette difficulté on peut utiliser à la place du codeur de la figure 10 le codeur dont le schéma est montré à la figure 13. Le signal à l'entrée 19 de ce codeur 1 est le signal MIC linéaire $Y'$ formé par arrondi avec changement de signe. Le codeur comporte un circuit de différence 50 dont une entrée reçoit le signal $Y'$ et dont l'autre entrée reçoit le signal de prédiction $\hat{y}'$ fourni par le filtre de prédiction 3 qui est identique à celui des codeurs des figures 6 et 8. Le signal à la sortie du circuit de différence 50 est appliqué au circuit de quantification et d'écrêtage 51, qui en cas d'écrêtage fournit le signal appelé $x_1$. Le circuit additionneur 52 auquel sont appliqués le signal de différence écrête $x_1$ et le signal de prédiction $\hat{y}'$ fournit un signal reconstitué $y'_1$ qui est différent du signal $Y'$, notamment à cause de l'écrêtage.

Ce signal $y'_1$ est appliqué au montage en série des circuits de compression 53 et d'extension 54 qui effectuent les mêmes opérations que les circuits correspondants 35 et 30 dans le montage en cascade de la figure 9. Le signal $y''_1$ à la sortie du circuit d'extension répond à la relation suivante (5b), analogue à (5a):

$$(5b) \qquad y''_1 \varepsilon \left] y'_1 - \frac{\Delta'}{2}, y'_1 + \frac{\Delta'}{2} \right]$$

où $\Delta'$ est le pas de l'arrondi correspondant à l'opération de compression-extension effectuée dans les circuits 53, 54.

Le signal $y''_1$ est appliqué au circuit 55 effectuant un arrondi avec changement de signe au pas du MIC différentiel et fournissant un signal $y'^*_1$. Dans le cas envisagé où

$$\frac{\Delta'}{2} \geqslant \frac{\Delta}{2},$$

ce signal $y'^*_1$ peut avoir une valeur différente de $y'_1$. Le signal $y'^*_1$ est appliqué à un circuit de codage avec écrêtage, comportant le circuit de différence 56 dont une entrée reçoit le signal $y'^*_1$, dont l'autre entrée reçoit le signal de prédiction $\hat{y}'$ et dont la sortie fournit le signal de différence $x'$. Le signal de différence $x'$ est appliqué au circuit de quantification et d'écrêtage 57 identique au circuit 51, qui fournit le signal $X'$ constituant le signal MIC différentiel de sortie du codeur, ce dernier signal étant appliqué également au filtre de prédiction 3 du codeur.

Si le signal de différence $x'$ est écrêté par le circuit de quantification et d'écrêtage 57, le signal de sortie $X'$ de ce dernier sera égal au signal $x_1$ fourni par le circuit de quantification et d'écrêtage 51. On en déduit que si l'on applique le signal $X' = x_1$ de sortie du codeur à un décodeur distant, (tel que 34 sur la figure 9) suivi d'un circuit de compression (tel que 35) et d'un circuit d'extension (tel que 30), on retrouvera à la sortie de ce dernier le signal $Y''_1 = y''_1$. En répétant dans un montage en cascade les mêmes opérations de codage et de décodage avec extension et compression, on retrouvera toujours le même signal $y''_1$ à la sortie des circuits d'extension.

Si le signal de différence $x'$ n'est pas écrêté par le circuit de quantification et d'écrêtage 57, le signal $X'$ de sortie du codeur est tel que $X'=x'$. Cela revient donc à avoir altéré la valeur du signal à coder $Y'$ pour le premier codage en la remplaçant par une quantité égale à $y'^*_1$, telle que le décodeur distant saura la restituer exactement et qui, appliquée à un autre codeur, permettra d'obtenir la même valeur $x'$ pour le signal MIC différentiel.

On effectue donc localement des opérations équivalentes à la mise en cascade de deux transcodeurs successifs et on ne retient pour la transmission en MIC différentiel que les valeurs permettant l'alignement de ces deux transcodeurs.

Ainsi, l'emploi du codeur de la figure 13 permet, quelles que soient les valeurs respectives des pas d'arrondi $\Delta$ et $\Delta'$, de monter en cascade des codeurs et des décodeurs avec des circuits d'extension et de compression associés, sans autre dégradation du signal que celle produite par le premier codage. Toutefois, dans la plupart des applications pratiques, les spectres des signaux sont tels qu'ils conduisent très rarement à se trouver dans le cas où

$$\frac{\Delta'}{2} \gtrsim \frac{\Delta}{2},$$

de sorte que l'on peut souvent se contenter d'utiliser le schéma plus simple du codeur de la figure 10, sans dégradation notable du signal dans les codages successifs.

On a décrit jusqu'à présent le système de transmission de l'invention, en supposant pratiquement que la quantification du signal de différence E était effectuée avec un échelon de grandeur fixe. Or, le signal d'erreur E dépend des variations de niveau du signal MIC à coder et pour ne pas dégrader de façon inacceptable le signal à transmettre, il est nécessaire d'adapter automatiquement la grandeur de l'échelon de quantification à la grandeur du signal E, cette adaptation étant usuellement effectuée pour les signaux vocaux, avec une constante de temps de l'ordre de la durée d'une syllabe.

Sur la figure 14, on a représenté la structure générale d'un codeur MIC différentiel à échelon de quantification variable, tandis que la figure 15 représente sous la même forme le décodeur distant correspondant.

Le codeur de la figure 14 comporte un certain nombre d'éléments déjà représentés sur les figures précédentes (par exemple la figure 10) et munis des mêmes références. Pour quantifier le signal d'erreur E avec un échelon de quantification $\Delta$ variable, on utilise un quantifacteur variable 60 qui est connecté à la sortie du circuit de différence 2 et qui doit fournir le signal MIC différentiel X à transmettre avec 4 bits. Ce quantificateur variable 60 comporte un compresseur 61 réalisé sous la forme d'un circuit diviseur et un circuit de quantification et d'écrêtage 63. Le circuit diviseur 61 divise les nombres du signal d'erreur E par les nombres du signal Q représentant la grandeur q de l'échelon variable de quantification, ce signal Q étant disponible à la sortie 65 du réseau de compression 64 qui détermine la grandeur de l'échelon de quantification à partir du signal X de sortie du codeur. Le circuit de quantification et d'écrêtage 63 connecté à la sortie du circuit diviseur 61, reçoit également le signal Q représentant la grandeur q de l'echelon variable et opère de façon que la réponse globale X du quantificateur 60, au signal de différence E soit du type représenté à la figure 11 avec une loi de quantification linéaire ou du type représenté à la figure 12 avec une loi de quantification non linéaire.

On suppose maintenant dans une première étape de la description d'un système à échelon de quantification variable, que l'on utilise un quantificateur 60 ayant une loi de quantification linéaire. Le fonctionnement détaillé de ce quantificateur est expliqué à l'aide du tableau I ci-dessous.

Tableau I

| | $2^{11}$ | $2^{10}$ | — | — | — | — | — | $2^4$ | $2^3$ | $2^2$ | $2^1$ | $2^0$ |
|---|---|---|---|---|---|---|---|---|---|---|---|---|
| Y | x | x | x | x | x | x | x | x | x | x | x | x |
| E | S | x | x | x | x | x | x | x | 0 | 0 | 0 | 0 |
| $\dfrac{E}{c}$ | S | S | S | S | S | x | x | x | x | x | x | x |
| $\hat{Y}$ | | | | | | | | | S | x | x | x |
| XQ | S | S | S | S | S | x | x | x | 0 | 0 | 0 | 0 |

Sur la deuxième ligne de ce tableau on a représenté par des crois les 12 bits à valeur variable du signal MIC linéaire Y, qui est appliqué au circuit d'arrondi 22, les poids de ces bits, allant de $2^{11}$ à $2^0$ étant indiqués sur la première ligne. On a vu ci-dessus que les signaux $Y'$ et $\hat{Y}'$ appliqués aux entrées du circuit de différence 2 résultent d'arrondis effectués avec un pas égal à l'échelon de quantification du MIC différentiel. En supposant que cet échelon est égal à une puissance de 2, par exemple $2^4$, les signaux $Y'$ et $\hat{Y}'$ arrondis et donc le signal d'erreur E comportent toujours 4 bits de valeur nulle, ayant des poids allant de $2^3$ à $2^0$. Le signal d'erreur E ayant cette structure est indiqué à la troisième ligne du tableau I, S représentant son bit de signe. Le circuit diviseur 61 qui divise le signal d'erreur E par le signal Q représentant la grandur de l'échelon de quantification, fournit le signal quotient

$$\frac{E}{Q}$$

qui, dans l'exemple choisi où cet échelon est de $2^4$, s'obtient simplement en décalant le signal E de 4 bits vers la droite, comme l'indique la quatrième ligne du tableau I. Si le signal quotient

$$\frac{E}{Q}$$

comporte avec le bit de signe plus de 4 bits à valeur variable (ce qui est les cas dans l'exemple choisi), le circuit d'écrêtage 63 fournit un signal X à 4 bits correspondant à la valeur maximum d'un signal représentable avec 4 bits. Si le signal quotient

$$\frac{E}{Q}$$

comporte 4 bits au moins, le circuit d'écrêtage 63 transmet sans modification ce signal

$$\frac{E}{Q}$$

en le complétant éventuellement à gauche par des zéros. Dans les deux cas, on transmet un signal X résultant ou non d'un écrêtage et comportant 4 bits, comme l'indique la cinquième ligne du tableau I.

Le signal Q représentant la grandeur de l'échelon de quantification et disponible à la sortie 65 du réseau de compression est également appliqué à l'extenseur 66 qui effectue sur le signal MIC différentiel X une opération inverse de celle effectuée dans le compresseur 61, c'est-à-dire dans l'exemple envisagé une multiplication du signal X par le signal Q. Le signal produit X.Q s'obtient simplement dans l'exemple précité où l'échelon de quantification a pour valeur $2^4$, en décalant de 4 bits vers la gauche, les bits du signal X, et en complétant a` droite par des zéros, comme le montre la sixième ligne du tableau I. Le signal X.Q fourni par l'extenseur 66 représente ainsi le signal X avec le même unité que celle avec laquelle est exprimé le signal d'erreur E, c'est-à-dire une unité égale au pas de quantification du signal MIC à coder Y.

Le signal de sortie de l'extenseur 66 est appliqué au filtre de prédiction 3 fournissant le signal de prédiction $\hat{Y}'$. Suivant les explications déjà données, on peut représenter ce filtre de prédiction 3 comme formé par un ensemble 6 de filtres à convergence absolue et/ou statistique, montés en cascade — cet ensemble ayant d'une manière générale la fonction de transfert

$$\frac{H(z)}{G(z)}$$

— et par un opérateur 7 ayant la fonction de transfert

$$\left[ 1 - \frac{G(z)}{H(z)} \right].$$

Par ailleurs, on a représenté sur la figure 14, une liaison entre la sortie 65 du réseau de compression 64 et l'ensemble 6 de filtres statistiquement convergents pour indiquer que l'opération d'arrondi dans chacun de ces filtres est effectuée avec un pas égal à la grandeur de l'échelon de quantification variable représentée par le signal Q. De même la liaison entre la sortie 65 et le circuit d'arrondi 22 du signal MIC Y, indique que l'opération d'arrondi dans le circuit 22 est également effectuée avec un pas égal à la grandeur de l'echelon de quantification variable.

Dans le codeur à échelon de quantification variable de la figure 14, le décodeur local est constitué par l'ensemble 67 comprenant le réseau de compression 64, l'extenseur 66 et l'ensemble 6 de filtres statistiquement convergents, ces éléments étant connectés entre eux comme l'indique la figure. La sortie de l'ensemble 6 de filtres constitue la sortie du décodeur local. Ce décodeur local reçoit le signal

# 0 011 341

MIC différentiel X, résultant d'un codage avec un échelon de quantification variable et restitue le signal MIC Y' arrondi avec un pas égal audit échelon de quantification variable.

Le schéma du décodeur distant à associer au codeur de la figure 14 est représenté sur la figure 15. Ce décodeur distant a exactement la même structure que le décodeur local incorporé dans le codeur et ses éléments sont représentés avec les mêmes références munies toutefois d'un accent.

Le réseau de compression 64 du codeur de la figure 14 comporte en cascade un premier opérateur non linéaire 68, un filtre syllabique 69 et un deuxième opérateur non linéaire 70. L'opérateur non linéaire 68 agit de façon instantanée et fait correspondre au signal X de sortie du codeur, un signal u, en affectant à chaque nombre du signal X un certain poids suivant une loi à préciser par la suite. Le filtre syllabique 69 est un filtre passe-bas ayant une constante de temps de l'ordre de la durée d'une syllabe et fournissant un signal v. Conformément à l'invention, ce filtre 69 est du type statistiquement convergent; donc il peut être formé dans le cas général d'une cascade de cellules de filtrage telles qu'on les a définies ci-dessous, chaque cellule ayant son propre dispositif d'arrondi (ou de troncation), effectuant un arrondi (ou une troncation) avec un pas fixe, les valeurs d'entrée du filtre étant exprimées en fonction de ce pas par un nombre entier. Ce filtre syllabique 69 peut être construit de façon très simple comme un filtre purement récursif du premier ordre auquel il est avantageux d'imposer certaines conditions à préciser par la suite. Enfin l'opérateur non linéaire 70 agit de façon instantanée en faisant correspondre aux nombres du signal v, les nombres q du signal Q représentant la grandeur de l'échelon de quantification, suivant une loi à préciser par la suite. Les nombres du signal Q sont exprimés avec une unité égale au pas de quantification du signal MIC Y à coder et sont avantageusement égaux à une puissance de deux. Le réseau de compression 64' du décodeur distant de la figure 15 est formé des mêmes éléments portant les mêmes références munies d'un accent.

On a déjà montré qu'en associant un codeur et un décodeur distant travaillant avec le même échelon de quantification et utilisant les mêmes ensembles 6, 6' de filtres statistiquement convergents dans chacun desquels les opérations d'arrondi sont effectuées avec une pas égal audit échelon, le décodeur distant restitue le même signal MIC arrondi Y' que celui appliqué au codeur, après le temps nécessaire à l'alignement des deux ensembles de filtres 6, 6' qui constituent pratiquement le décodeur local et le décodeur distant.

Pour qu'il en soit ainsi dans un système à échelon de quantification variable, il est nécessaire que les réseaux de compression 64 et 64' du codeur et du décodeur distant fournissent le même signal Q, représentant la grandeur de l'échelon de quantification, en réponse au même signal X de sortie du codeur qui leur est appliqué. Les opérateurs non linéaires 68 et 68' qui sont des opérateurs instantanés fournissent instantanément le même signal u, en réponse au même signal X. Les filtres syllabiques 69, 69' attaqués par le même signal u et qui sont, conformément à l'invention, des filtres identiques du type à convergence statistique et/ou absolue fournissent le même signal v après la durée nécessaire à leur alignement. Enfin les opérateurs non linéaires instantanés 70 et 70' fournissent instantanément le même signal Q, en réponse au même signal v. Finalement, après le temps nécessaire à l'alignement des filtres syllabiques 70, 70', le décodeur distant de la figure 15 fournira le même signal MIC Y', que celui fourni par le décodeur local 67 inclus dans le codeur de la figure 14. On a pu vérifier pratiquement, qu'après un temps mettant en jeu la durée d'alignement des filtres syllabiques 69, 69' et la durée d'alignement des ensembles de filtres 6, 6', le décodeur distant de la figure 15 fournit le même signal MIC arrondi Y' que celui appliqué à l'entrée du codeur de la figure 14. On a pu vérifier également qu'il est possible de monter en cascade plusieurs codeurs et décodeurs de ce type, en obtenant les mêmes propriétés que celles déjà expliquées pour des codeurs et décodeurs à échelon de quantification fixe.

On va maintenant décrire les caractéristiques à donner au réseau de compression 64 et à ses éléments constituants 68, 69, 70 pour obtenir la meilleure adaptation possible de l'échelon de quantification. L'échelon de quantification est le mieux adapté lorsque le signal de différence E dans le codeur se trouve presque à la limite de l'écrêtage. Le réseau de compression 64 à incorporer dans le codeur, a pour but de réaliser au mieux cette adaptation de l'échelon de quantification en utilisant l'information constituée par le signal X et en prenant en compte les caractéristiques des signaux MIC appliqués à l'entrée du codeur.

Dans le premier élément 68 du réseau de compression 64, est effectuée une opération instantanée consistant à former la valeur absolue |X| des nombres du signal X, qui est représentative de l'amplitude du signal d'erreur E, puis à attribuer à ces nombres |X| des poids déterminés. Cette opération est basée sur divers résultats observés en pratique. La probabilité d'apparition des nombres |X| de faible valeur (de 0 à 4 environ) varie très peu en fonction de la qualité de l'adaptation de l'échelon de quantification, alors qu'au contraire la probabilité d'apparition des nombres |X| de forte valeur (de 5 à 8) est très sensible à la qualité de l'adaptation. Par ailleurs la loi de distribution des amplitudes des signaux MIC à coder, conduit à une probabilité d'apparition des nombres |X| de faible valeur, beaucoup plus grande que celle des nombres |X| de forte valeur. Ces deux effets conduisent pratiquement, dans l'opérateur 68, à attribuer aux nombres |X| des poids résultant d'une approximation simple d'une lois exponentielle: par exemple, à plusieurs nombres |X| de valeur faible on peut attribuer un poids nul et aux nombres |X| de forte valeur, des poids élevés dépendant du type de signaux MIC à coder: signaux de parole et/ou signaux de données.

Le filtre syllabique 69 qui traite le signal u obtenu comme on vient de l'expliquer dans l'opérateur

18

68, est de préférence un filtre récursif du premier ordre, ayant un coefficient $\alpha$ inférieur à 1 et répondant donc à la propriété de convergence statistique. Ce filtre ayant une fonction d'intégration a une constante de temps de l'ordre de la durée d'une syllabe et fournit donc un signal de sortie v correspondant à la moyenne des nombres du signal u, calculée pendant ladite durée. A la constante de temps relativement élevée imposée à ce filtre (8 mS environ), correspond un coefficient $\alpha$ proche de 1 (par exemple

$$\alpha = 1 - \frac{1}{256}).$$

Suivant les propriétés mentionnées plus haut pour les filtres du premier ordre, il en résulte que, lorsque les filtres syllabiques 69 et 69' du codeur et du décodeur ont des conditions initiales différentes et sont attaqués par le même signal d'entrée, l'alignement final ne peut être obtenu que pour une valeur prise par ce signal d'entrée parmi 256. Il faut donc éviter que, lorsque le signal MIC à coder a un niveau constant pendant une longue durée, les sorties des filtres syllabiques du codeur et du décodeur puissent se stabiliser sur des valeurs voisines, mais différentes, procurant par l'intermédiaire de l'opérateur 70 des échelons de quantification différents dans le codeur et dans le décodeur.

On examine maintenant le fonctionnement de l'opérateur 70 et les mesures prises pour pallier l'inconvénient que l'on vient de mentionner.

Cet opérateur 70 fait correspondre à chaque nombre du signal v fourni par le filtre syllabique 69, une valeur q d'échelon de quantification, suivant une loi exponentielle approchée du type:

$$(7) \qquad\qquad q = q_m 2^{E[v/A]}$$

Dans cette expression (7):

— l'opérateur E[ ] signifie partie entière de
— $q_m$ est la valeur minimum de l'échelon de quantification q, que l'on prend égale à l'échelon de quantification du signal MIC linéaire, puis-qu'il n'est pas nécessaire de quantifier le signal d'erreur E avec une meilleure définition que celle du signal MIC.
— A est une constante qui fixe la plage des valeurs v de sortie du filtre syllabique auxquelles on fait correspondre la même valeur de l'échelon de quantification.

L'adoption d'une loi exponentielle suivant la formule (7) pour former l'échelon de quantification a notamment pour effet de minimiser l'influence des fluctuations dont est affecté le signal de sortie v du filtre syllabique sur la détermination de l'echelon de quantification q, l'amplitude de ces fluctuations étant indépendante de la sortie du filtre.

Pour pallier l'inconvénient précité, relatif à la convergence finale des filtres syllabiques du codeur et du décodeur il est avantageux de relier la valeur de la constante A de la formule (7) à la valeur du coefficient $\alpha$ de ces filtres, suivant la relation:

$$(8) \qquad\qquad A = K . M$$

où K est un nombre entier supérieur à 1
et M est tel que

$$\alpha = 1 - \frac{1}{M}.$$

Si l'on choisit par exemple K=2 avec un coefficient

$$\alpha = 1 - \frac{1}{256}$$

(c'est-à-dire M=256), la formule (7) ci-dessus devient:

$$(9) \qquad\qquad q = q_m 2^{E[v/512]}$$

On peut en déduire qu'en utilisant deux filtres syllabiques à coefficients

$$\alpha = 1 - \frac{1}{256}$$

et en déterminant l'échelon de quantification q suivant la formule (9), la convergence finale de ces deux filtres est forcément obtenue. En effet, dans ces conditions, à chaque fois que les signaux de sortie v et v' des filtres syllabiques du codeur et du décodeur distant correspondront à des valeurs distinctes d'échelons de quantification, les valeurs réinjectées dans la mémoire de ces filtres syllabiques qui correspondent aux valeurs

$$v\left(1-\frac{1}{M}\right) \text{ et } v'\left(1-\frac{1}{M}\right)$$

ayant subi une troncation pour ne garder que la partie entière, seront telles que leur écart sera inférieur d'au moins une unité à celui qui séparait v et v'. Ainsi il ne peut y avoir qu'un nombre fini de cas où le codeur et le décodeur travailleront avec des échelons de quantification différents.

Il est avantageux enfin de limiter l'excursion de la sortie du filtre syllabique 69, à deux bornes minimum $v_{min}$ et maximum $v_{max}$. L'utilisation d'une borne minimum dans le filtre syllabique permet de garantir une perte de mémoire dans ce filtre avec une pente minimum, même si le contenu de ce filtre est à une valeur correspondant à un échelon de quantification au voisinage de l'échelon minimum. D'autre part la borne maximum correspond à la limite de la plage définissant l'échelon maximum utilisé, donc à la plage des neveaux de sortie du filtre syllabique. L'utilisation de ces bornes revient à écrire la formule (9) donnant le pas de quantification.

(10) $$q=q_m 2^{E[v-v_{min}/512]}$$

avec $0 \leqslant v-v_{min} < v_{max}$.

Le domaine des valeurs de sortie $v-v_{min}$ du filtre syllabique 69, peut être formé par exemple de 12 plages distinctes ayant chacune, d'après la formule (10), une largeur égale à 512 et correspondant à des échelons de quantification allant de $q_m$ à $2^{11}$. Le tableau II ci-dessous indique pratiquement dans ce cas la correspondance effectuée dans l'opérateur 70, entre les 12 plages de la sortie $v-v_{min}$ du filtre syllabique 69 et les 12 échelons de quantification.

Tableau II

| $v-v_{min}$ | [0,512[ | [512,1024[ | [1024,1536[ | .... | [5632,6144[ |
|---|---|---|---|---|---|
| q | $q_m$ | $2q_m$ | $4q_m$ | .... | $2^{11}q_m$ |

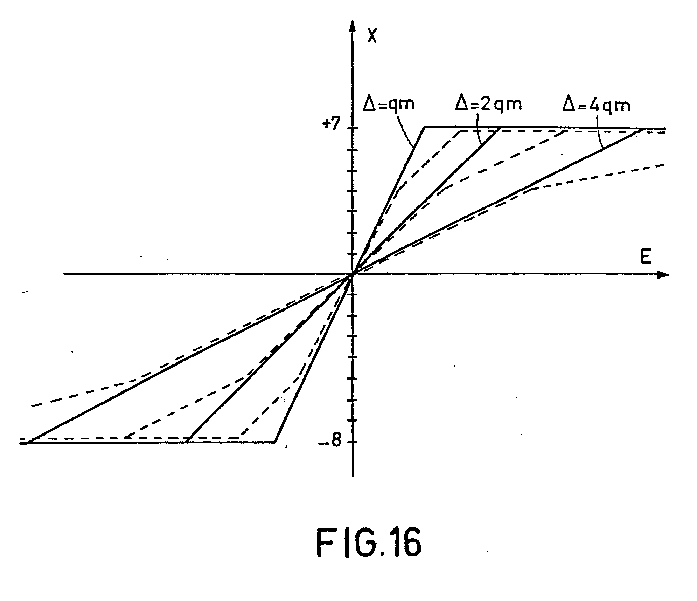

Dans le cas envisagé jusqu'à présent où le quantificateur écréteur 63 a une loi de quantification linéaire (du type indiqué à la figure 11), on a indiqué sur la figure 16, par les courbes en trait plein la réponse X du quantificateur variable 60 au signal de différence E, pour les différentes valeurs d'échelons de quantification du tableau II; $q_m$, $2q_m$, $4q_m$ ... etc. Pour chaque valeur d'échelon $\Delta$, la réponse dans la plage sans écrêtage est représentée de façon approchée par un segment en regard duquel est portée la valeur de l'échelon. On voit facilement que dans ce cas, les plages du signal E traité sans écrêtage varient de 6 dB entre deux réponses consécutives.

Le quantificateur ecrêteur 63 peut avoir aussi une loi de quantification non linéaire et il est aisé de comprendre que dans ce cas, le circuit multiplicateur 66 du codeur doit être précédé d'un circuit 71 ayant une fonction de transfert inverse de celle du quantificateur écrêteur 63, et représenté en traits pointillés sur la figure 14, tandis que dans le décodeur distant le circuit multiplicateur 66' doit également être précédé d'un circuit 71' identique au circuit 71 du codeur et représenté en traits pointillés sur la figure 15.

Le quantificateur écrêteur 63 peut avoir par exemple la loi de quantification non linéaire indiquée à la figure 12 et caractérisée, comme on l'a vu, par un échelon minimum de quantification utilisé pour une première plage des valeurs de E entourant zéro et par un échelon double de l'échelon minimum, utilisé pour deux plages prolongeant la première plage jusqu'à l'écrêtage. Dans ce cas, on a représenté sur la figure 16, par des courbes en pointillé, la réponse X du quantificateur variable 60 au signal de différence E, pour des valeurs minimum d'échelon de quantification $q_m$, $2q_m$, $4q_m$ ... etc. Pour chaque valeur d'échelon minimum, la réponse dans la plage sans écrêtage est représentée de façon approchée par une courbe à 3 segments, formée d'un segment autour de l'origine correspondant à une quantification avec l'échelon minimum et par deux segments prolongeant le premier segment jusqu'à l'écrêtage et correspondant à une quantification avec un échelon double de l'échelon minimum.

Il est avantageux d'utiliser un quantifacteur écrêteur 63 commandé pour avoir alternativement une loi linéaire et une loi non linéaire, quand le signal de sortie $v-v_{min}$ varie dans le même sens. Comme on peut le déduire aisément de la figure 16, on a alors un étagement des plages de quantification sans écrêtage du signal E, meilleur que si l'on utilise toujours la même loi de quantification: entre deux lois linéaire et non linéaire consécutives, la largeur de ces plages varie environ de 3 dB, alors qu'elle varie de 6 dB entre deux lois de même nature consécutives.

20

# 0011 341

En complément du tableau II le tableau III ci-dessous indique comment le domaine des valeurs de sortie $v-v_{min}$ du filtre syllabique 69 peut être subdivisé dans l'opérateur 70, pour déterminer 12 échelons minimum de quantification allant de $q_m$ à $2^{11}q_m$ et une alternance d'une loi de quantification linéaire et d'une loi de quantification non linéaire.

Tableau III

| $v-v_{min}$ | [0,256[ | [256,512[ | [512,768[ | [768,1024[ | .... | [5632,5888[ | [5888,6144[ |
|---|---|---|---|---|---|---|---|
| q | $q_m$ | $q_m$ | $2q_m$ | $2q_m$ | .... | $2^{11}q_m$ | $2^{11}q_m$ |
| Loi | Linéaire | Non Linéaire | Linéaire | Non Linéaire | .... | Linéaire | Non Linéaire |

D'une manière plus générale, on peut utiliser un quantificateur écrêteur 63 commandé pour avoir successivement M lois de quantification linéaires ou non linéaires (M=2 dans l'exemple précité) pour chacune des L valeurs possibles d'échelon de quantification minimum (L=12 dans l'exemple précité). On peut alors obtenir un étagement entre les plages de quantification du signal E, aussi bon que l'on veut. Il est évidemment avantageux que les échelons de quantification utilisés pour former les M lois de quantification soient pris parmi les L échelons minimum qui sont eux-mêmes entre eux dans un rapport égal à une puissance de deux. De la même manière qu'on l'a représenté au tableau III pour le cas où M=2 et L=12, le domaine des valeurs de sortie $v-v_{min}$ du filtre syllabique 69 sera divisé dans l'opérateur 70, en L . M plages distinctes, chacune de ces plages déterminant dans le quantificateur variable 60, une quantification avec une loi déterminée parmi M, avec un échelon minimum déterminé parmi L.

## Revendications

1. Système de transmission numérique d'informations, utilisant la modulation différentielle par codage d'impulsions et comportant un codeur (1) dans lequel le signal MIC différentiel (X) a transmettre résulte de la quantification du signal de différence (E) entre le signal MIC linéaire entrant (Y) et un signal de prédiction $(\hat{Y})$ fourni par un filtre de prédiction (3) comportant un décodeur local (6) recevant ledit signal MIC différentiel, le décodeur local (6) et le décodeur distant (4) comportant des filtres de même structure, caractérisé en ce que ces filtres sont constitués chacun par une ou plusieurs cellules de filtrage en cascade de type purement récursif ($F_{10}$) et/ou non récursif ($F'_{10}$) ayant un seul coefficient différent de zéro et de valeur absolue inférieure à une, et les quantificateurs (14), (14') (22) utilisés pour arrondir (ou tronquer) les signaux dans lesdites cellules de filtrage et le signal MIC linéaire entrant sont commandés pour effectuer les opérations d'arrondi (ou de troncation) avec un pas égal à la grandeur de l'échelon de quantification dudit signal de différence.

2. Système de transmission selon la revendication 1, dans lequel le codeur (32) est précédé d'un circuit d'extension (30) pour convertir un signal MIC comprimé (Z) en un signal MIC linéaire (Y) et le décodeur (34) est suivi d'un circuit de compression (35) pour convertir le signal MIC linéaire (Y') en signal MIC comprimé (Z'), caractérisé en ce que le signal (Y) fourni par le circuit d'extension (30) est changé de signe à l'entrée du quantificateur (31) utilisé pour arrondir (ou tronquer) ledit signal MIC linéaire, le signe initial étant rétabli à la sortie de ce quantificateur.

3. Système de transmission selon la revendication 2, dans lequel le codeur comporte un premier circuit écrêteur (51) pour écrêter ledit signal de différence (E) entre le signal MIC linéaire entrant (Y') et le signal de prédiction $(\hat{Y}')$, caractérisé en ce que ce codeur comporte en outre un circuit additionneur (52) pour former la somme du signal de différence écrête ($X_1$) et du signal de prédiction $(\hat{Y}')$, la sortie de ce circuit additionneur étant connectée au montage en cascade d'un circuit de compression (53), d'un circuit d'extension (54) et d'un quantificateur d'arrondi (ou de troncation) (55), identiques respectivement au circuit de compression (35) disposé après le décodeur, au circuit d'extension (30) et au quantificateur d'arrondi (ou de troncation) (31) disposés avant le codeur, le signal ($Y'_1$) a la sortie dudit montage en cascade étant appliqué à un dispositif de codage MIC différentiel utilisant ledit signal de prédiction $(\hat{Y}')$ et un circuit écrêteur (57) identique au premier circuit écrêteur (51) et fournissant le signal MIC différentiel (X') à transmettre.

4. Système de transmission selon l'une quelconque des revendications 1 à 3, comportant dans le décodeur local et le décodeur distant des réseaux de compression identiques (64, 64') recevant le signal MIC différentiel (X) et servant à régler automatiquement la grandeur de l'échelon de quantification dudit signal de différence, caractérisé en ce que chaque réseau de compression comporte en cascade un premier opérateur instantané (68) pondérant les nombres du signal MIC différentiel, un filtre syllabique (69) formé par une ou plusieurs cellules de filtrage en cascade de type purement récursif et/ou non récursif ayant un seul coefficient différent de zéro et de valeur absolue inférieure à un, enfin un deuxième opérateur instantané (70) faisant correspondre à chaque nombre du signal de sortie

**0011 341**

v du filtre syllabique (69) une valeur q d'échelon de quantification suivant une loi exponentielle approchée du type:

$$q=q_m 2^{E[V/A]}$$

où $q_m$ est la valeur minimum dudit échelon

A est une constante

E signifiant partie entière de la quantité qui suit.

5. Système de transmission selon la revendication 4, caractérisé en ce que le premier opérateur instantané (68) est agencé pour former les valeurs absolues des nombres du signal MIC différentiel et pour pondérer ces valeurs absolues selon une approximation simple d'une loi exponentielle.

6. Système de transmission selon l'une des revendications 4 et 5, caractérisé en ce que le filtre syllabique (69) est agencé pour que son signal de sortie v soit limité à une valeur minimum $v_{min}$ et à une valeur maximum $v_{max}$.

7. Système de transmission selon l'une quelconque des revendications 4 à 6, caractérisé en ce que le filtre syllabique (69) est un filtre purement récursif du premier ordre.

8. Système de transmission selon l'une des revendications 6 et 7, caractérisé en ce que le deuxième opérateur instantané (70) est agencé pour former un signal donnant la valeur q d'échelon de quantification selon la loi:

$$q=q_m 2^{E[v-v_{min}/A]}$$

où $v_{min}$ est une valeur minimum du signal de sortie du filtre syllabique.

9. Système de transmission selon les revendications 7 et 8, caractérisé en ce que la constante A est reliée au coefficient $\alpha$ dudit filtre purement récursif du premier ordre par la relation

$$A=K\frac{1}{1-\alpha},$$

K étant un nombre entier supérieur à 1.

10. Système de transmission selon l'une des revendications 8 et 9, caractérisé en ce que le deuxième opérateur instantané (70) divise le domaine des valeurs du signal de sortie du filtre syllabique (69) en L plages distinctes pour former L valeurs discrètes d'échelons de quantification allant de $q_m$ à $2^{L-1}q_m$, ces L valeurs étant utilisées dans un quantificateur (60) linéaire ou non linéaire par segments pour quantifier ledit signal de différence (E) entre le signal MIC linéaire (Y') et le signal de prédiction (Ŷ').

11. Système de transmission selon l'une des revendications 8 et 9, caractérisé en ce que le deuxième opérateur instantané (70) divise le domaine des valeurs du signal de sortie du filtre syllabique (69) en L plages distinctes pour former L valeurs discrètes d'échelon de quantification allant de $q_m$ à $2^{L-1}q_m$ et divise chacune desdites plages en M sous-plages distinctes correspondant à M lois de quantification linéaire et non linéaires par segments pour commander à chaque instant dans le quantificateur (60) dudit signal de différence (E) une quantification selon la loi de quantification correspondant à la sous-plage à laquelle appartient audit instant la valeur du signal de sortie du filtre syllabique, les échelons dans ces lois de quantification étant formés à partir desdites L valeurs discrètes d'échelon de quantification.

### Claims

1. A digital information transmission system using differential pulse code modulation and comprising an encoder (1) in which the differential PCM signal (X) to be transmitted is formed by quantizing the difference signal (E) between the incoming linear PCM signal (Y) and a prediction signal (Ŷ) produced by a prediction filter (3) comprising a local decoder (6) receiving said differential PCM signal, the local decoder (6) and the remote decoder (4) comprising filters of the same structure, characterized in that these filters are each constructed from one or several filtering sections arranged in cascade, each filtering section being of the purely recursive ($F_{10}$) or non-recursive type ($F'_{10}$) with a sole coefficient differing from zero and having an absolute value less than 1, and that the roundoff (or truncation) operators (14), (14'), (22) which operate in said filtering sections and on the incoming linear PCM signal are controlled to realize these rounding (truncating) operations with a step equal to the quantizing step of said difference signal.

2. A transmission system as claimed in Claim 1, in which the encoder (32) is preceded by an expansion circuit (30) for converting a compressed PCM signal (Z) into a linear PCM signal (Y) and the decoder (34) is followed by a compression circuit (35) for converting the linear PCM signal (Y') into a compressed PCM signal (Z'), characterized in that the sign of the signal (Y) produced by the expansion circuit (30) is changed at the input of the roundoff (or truncation) operator (31) which operates on the linear PCM signal, the initial sign being restored at the output of this operator.

22

3. A transmission system as claimed in Claim 2, in which the encoder comprises a first limiter circuit (51) for limiting said difference signal (E) between the incoming linear PCM signal (Y′) and the prediction signal ($\hat{Y}$′), characterized in that this encoder comprises *inter alia* an adder circuit (52) for forming the sum of the limited difference signal ($X_1$) and the prediction signal ($\hat{Y}$′), the output of this adder circuit being connected to the cascade arrangement of a compression circuit (53), an expansion circuit (54) and a roundoff (or trunction) operator (55), which are identical to the compression circuit (35) arranged behind the decoder, to the expansion circuit (30) and to the roundoff (or truncation) operator (31) preceding the encoder, respectively, the signal ($Y′_1$*) at the output of the said cascade arrangement being applied to a differential PCM coding device which utilizes the said prediction signal ($\hat{Y}$′) and a limiter circuit (57) identical to the first limiter circuit (51) and producing the differential PCM signal (X′) to be transmitted.

4. A transmission system as claimed in any one of the Claims 1 to 3, in which the quantizing step of said difference signal is automatically controlled by means of identical compression networks (64, 64′) incorporated in the local decoder and the remote decoder and receiving the transmitted differential PCM signal (X), characterized in that each compression network comprises in cascade a first instantaneous operator (68) weighting the numbers of the differential PCM signal, a syllabic filter (69) formed by one or several filtering sections of the purely recursive or non-recursive type arranged in cascade, each having a sole coefficient differing from zero and having an absolute value less than 1, and finally a second instantaneous operator (70) which causes a value $q$ of the quantity step to correspond to each number of the output signal $v$ of the syllabic filter (69) in accordance with an approximated exponential law of the type:

$$q = q_m 2^{E[v/A]}$$

where

$q_m$ is the minimum value of said step

A is a constant

E represents the integral part of the quantity subsequent to it.

5. A transmission system as claimed in Claim 4, characterized in that the first instantaneous operator (68) is arranged so as to form the absolute values of the numbers of the differential PCM signal and two weight these absolute values in accordance with a simple approximation of an exponential law.

6. A transmission system as claimed in one of the Claims 4 and 5, characterized in that the syllabic filter (69) is so arranged that its output signal $v$ is limited to a minimum value $v_{min}$ and to a maximum value $v_{max}$.

7. A transmission system as claimed in any one of the Claims 4 to 6, characterized in that the syllabic filter (69) is a first-order, purely recursive filter.

8. A transmission system as claimed in one of the Claims 6 and 7, characterized in that the second instantaneous operator (70) is arranged so as to form a signal giving the value $q$ of the quantizing step in accordance with the law:

$$q = q_m 2^{E[v - v_{min}/A]}$$

where

$v_{min}$ is a minimum value of the output signal of the syllabic filter.

9. A transmission system as claimed in the Claims 7 and 8, characterized in that the constant A is related to the coefficient $\alpha$ of said first-order purely recursive filter by the relation

$$A = K \frac{1}{1 - \alpha},$$

K being an integer greater than 1.

10. A transmission system as claimed in one of the Claims 8 and 9, characterized in that the second instantaneous operator (70) divides the domain of the output values of the syllabic filter (69) into L distinct ranges for forming L discrete values of the quantizing steps ranging from $q_m$ to $2^{L-1}q_m$, these L values being used in a linear or segment-wise non-linear quantizer (60) for quantizing said difference signal (E) between the linear PCM signal (Y′) and the prediction signal ($\hat{Y}$′).

11. A transmission system as claimed in one of the Claims 8 and 9, characterized in that the second instantaneous operator (70) divides the domain of the output values of the syllabic filter (69) into L distinct ranges for forming L discrete values of the quantizing steps ranging from $q_m$ to $2^{L-1}q_m$, and divides each of said ranges into M distinct sub-ranges, corresponding to M linear and segment-wise non-linear quantizing laws, to control at each time instant, in the quantizer (60) of said difference signal (E), a quantizing operation in accordance with a quantizing law corresponding to the subrange to which belongs the value of the syllabic filter output signal at the said time instant, the steps in these quantizing laws being formed from the said L discrete values of the quantizing step.

# 0011341

**Patenansprüche**

1. Digitales, Differenz-Pulscodemodulation benutzendes Informationsübertragungssystem mit einer Codieranordnung (1), in der das zu übertragende Differenz-Pulscodemodulationssignal (x) resultiert aus einer Quantisierung des Differenzsignals (E) zwischen dem eintreffenden linearen Pulscodemodulationssignal (y) und einem Vorhersagesignal ($\hat{y}$), das durch ein Vorhersagefilter (3), das eine das genannte Differenz-Pulscodemodulationssignal empfangende, örtliche Decodieranordnung (6) enthält, geliefert wird, wobei die örtliche Decodieranordnung (6) und die ferne Decodieranordnung (4) Filter derselben Struktur enthalten, dadurch gekennzeichnet, dass diese Filter aus einem oder mehreren reihengeschalteten Filterabschnitten gebildet sind, wobei jeder Filterabschnitt vom rein rekursiven ($F_{10}$) bzw. nicht-rekursiven Typ ($F'_{10}$) ist mit nur einem Koeffizienten, der von Null abweicht und einen Absolutwert weniger als eins hat, und dass die Quantisieranordnungen (14), (14'), (22) die zum Runden (bzw. Abschneiden) der Signale in den genannten Filterabschnitten und des eintreffenden linearen Pulscodemodulationssignals benutzt werden, zum Durchführen dieser Rundungen (bzw. Abschnitte) mit einem Schritt entsprechend dem Quantisierungsschritt des genannten Differenzsignals gesteuert werden.

2. Übertrangungssytem nach Anspruch 1, in dem der Codieranordnung (32) eine Expansionsschaltung (30) zur Umwandlung eines komprimierten Pulscodemodulationssignals (z) in ein lineares Pulscodemodulationssignal (y) vorhergeht und wobei der Decodieranordnung (34) eine Kompressionsschaltung (35) folgt zur Umwandlung des linearen Pulscodemodulationssignals (y') in ein komprimiertes Pulscodemodulationssignal (z'), dadurch gekennzeichnet, dass das Vorzeichen des von der Expansionsschaltung (30) gelieferten Signals (y) am Eingang der Quantiseieranordnung (31) zum Runden (bzw. Abschneiden) des genannten linearen Pulscodemodulationssignals geändert wird, und das ursprüngliche Vorzeichen am Ausgang dieser Quantiseranordnung wiederhergestellt wird.

3. Übertrangungssystem nach Anspruch 2, in dem di Codieranordnung eine erste Begrenzungsschaltung (51) zum Begrenzen des genannten Differenzsignals (E) zwischen dem eintreffenden linearen Pulscodemodulationssignal (y') und dem Vorhersagesignal (y') enthält, dadurch gekennzeichnet, dass diese Codieranordnung ausserdem eine Addieranordnung (52) enthält zum Bilden der Summe aus dem begrenzten Differenzsignal ($x_1$) und dem Vorhersagesignal ($\hat{y}_1$), wobei der Ausgang dieser Addierschaltung mit der Reihenschaltung aus einer Kompressionsschaltung (53), einer Expansionsschaltung (54) und einer Rundungs-(bzw. Abschneidungs-)Quantisieranordnung (55) verbunden ist, die der Kompressionsschaltung (35) hinter der Decodieranordnung, der Expansionsschaltung (30) bzw. der Rundungs-(bzw. Abschneidungs-)Quantisieranordnung (31) vor der Codieranordnung entsprechen, wobei das Signal ($y'_1$*) am Ausgang der genannten Reihenschaltung einer differentiellen Pulscodemodulationsanordnung zugeführt wird, die das genannte Vorhersagesignal ($\hat{y}'$) sowie eine der ersten Begrenzungsschaltung (51) entsprechende Begrenzungsschaltung (57) benutzt und die das zu übertragende Differenz-Pulscodemodulationssignal (x') liefert.

4. Übertrangungssystem nach einem der Ansprüche 1 bis 3, wobei die örtliche Decodieranordnung und die ferne Decodieranordnung entsprechende Kompressionsnetzwerke (64, 64') enthalten, die das Differenz-Pulscodemodulationssignal (x) empfangen und die zur automatischen Regelung der Grösse des Quantisierungsschrittes des genannten Differnzsignals dienen, dadurch gekennzeichnet, dass jedes Kompressionsnetzwerk eine Reihenschaltung aus einem ersten Augenblicksoperator (68), der die Zahlen des Differenz-Pulscodemodulationssignals wägt, einem Silbenfilter (69) des durch eine oder mehrere reihengeschaltete Filterabschnitte vom rein rekursiven bzw. nicht-rekursiven Typ mit nur einem einzigen Koeffizienten, der von Null abweicht und einen absoluten Wert weiniger als eins hat, gebildet wird, und zum Schluss einen zweiten Augenblicksoperator (70) enthält, der aus jeder Zahl des Ausgangssignals des Silbenfilters (69) einen Wert q des Quantisierungsschrittes entsprechend einem angenäherten exponentiellen Gesetz vom Typ:

$$q = q_m 2^{E[v/A]}$$

erzeugt, wobei

$q_m$ der minimale Wert dieses Schrittes ist,

A eine Konstante ist,

E den ganzen Teil der nachfolgenden Grösse darstellt.

5. Übertrangungssystem nach Anspruch 4, dadurch gekennzeichnet, dass der erste Augenblicksoperator (68) die absoluten Werte der Zahlen des Differenz-Pulscodemodulationssignals bildet und diese absoluten Werte nach einer einfachen Annäherung eines exponentiellen Gesetzes wägt.

6. Übertragungssystem nach einem der Ansprüche 4 und 5, dadurch gekennzeichnet, dass das Silbenfilter (69) das Ausgangssignal v auf einen minimalen Wert $v_{min}$ und einen maximalen Wert $v_{max}$ begrenzt.

7. Übertragungssystem nach einen der Ansprüche 4 bis 6, dadurch gekennzeichnet, dass das Silbenfilter (69) ein rein rekursives Filter erster Ordnung ist.

8. Übertrangungssystem nach einem der Ansprüche 6 und 7, dadurch gekennzeichnet, dass der zweite Ausgenblicksoperator (70) ein Signal erzeugt, das einen Wert q des Quantisierungsschrittes gemäss dem nachfolgenden Gesetz:

24

**0 011 341**

$$q = q_m 2^{E[v - v_{min}/A]}$$

ergibt, wobei

$v_{min}$ ein minimaler Wert des Ausgangssignals des Silbenfilters ist.

9. Übertrangungssystem nach Anspruch 7 und 8, dadurch gekennzeichnet, dass die Konstante A den Koeffizienten $\alpha$ des genannten rein rekursiven Filters erster Ordnung durch die Beziehung

$$A = K \frac{1}{1 - \alpha}$$

angibt, wobei K eine ganze Zahl grösser als 1 ist.

10. Übertrangungssystem nach einem der Ansprüche 8 und 9, dadurch gekennzeichnet, dass der zweite Augenblicksoperator (70) den Bereich der Ausgangswerte des Silbenfilters (69) in L verschiedene Gebiete aufteilt zum Bilden von L diskreten Werten der Quantisierungsschritte von $q_m$ bis $2^{L-1}q_m$, wobei diese L Werte in einer linearen bzw. stückweise nicht-linearen Quantisieranordnung (60) zum Quantisieren des genannten Differenzsignals (E) zwischen dem linearen Pulscodemodulationssignal (y') und dem Vorhersagesignal (ŷ') benutzt werden.

11. Übertragungssystem nach einem der Ansprüche 8 und 9, dadurch gekennzeichnet, dass der zweite Augenblicksoperator (70) den Bereich der Ausgangswerte des Silbenfilters (69) in L verschiedene Gebiete aufteilt zum Bilden von L diskreten Werten der Quantisierungsschritte von $q_m$ bis $2^{L-1}q_m$ und jedes der genannten Gebiete in M Untergebiete, die M linearen bzw. stückweise nicht-linearen Gesetzen entsprechen, um zu jedem Augenblick in der Quantisieranordnung (60) des Differenzsignals (E) eine Quantisierung nach dem Quantisierungsgesetz zu regeln, das dem Untergebiet entspricht, zu dem der Wert des Silbenfilterausganssignals zu dem genannten Zeitpunkt gehört, wobei die Schritte in diesen Quantisierungsgesetzen aus den genannten L diskreten Werten des Quantisierungsschrittes gebildet werden.

25

FIG.1

FIG.2

FIG.3

FIG.4

0011341

FIG.5

FIG.6

2

FIG.7

FIG.8

3

FIG.9

FIG.10

FIG.13

4

FIG.11

FIG.12

FIG.14

FIG.15

FIG.16